# EUROPEAN PATENT APPLICATION

(11) **EP 4 836 627 A1**
(43) Date of publication of application: **04.11.2026**
(21) Application number: 25226863.6
(22) Date of filing: 23.12.2025
(51) Int. Cl.: H10D 30/47, H10D 62/85, H10D 64/00, H10D 64/23, H10D 64/27, H10D 64/60, H10D 62/824, H10D 30/01

(54) **SEMICONDUCTOR DEVICE INCLUDING A GATE SEMICONDUCTOR LAYER**

(30) Priority: 28.04.2025 KR 20250055759
(71) Applicant: Samsung Electronics Co., Ltd., Suwon-si, Gyeonggi-do 16677 (KR)
(72) Inventor: KIM, Joonyong, Suwon-si (KR); KIM, Jongseob, Suwon-si (KR); KIM, Myeongjin, Suwon-si (KR); SON, Chaeyeon, Suwon-si (KR); YANG, Seong Seok, Suwon-si (KR); JO, Junbeom, Suwon-si (KR); HWANGBO, Sumin, Suwon-si (KR)
(74) Representative: Marks & Clerk LLP

(57) **Abstract**

The present disclosure relates to a semiconductor device. An example semiconductor device includes a channel layer (132), a barrier layer (136) positioned on the channel layer and including a material having a different energy band gap from an energy band gap of the channel layer, a gate electrode (165) positioned on the barrier layer, a gate semiconductor layer (150) positioned between the barrier layer and the gate electrode, a gate spacer (200) positioned on opposite sides of the gate semiconductor layer, and source electrode and drain electrode positioned on opposite sides of the gate electrode and connected to the channel layer. The gate semiconductor layer includes a first pattern portion (151) overlapping the gate electrode, and a second pattern portion (152) positioned on opposite sides of the first pattern portion and overlapping the gate spacer, and a side of the second pattern portion is aligned with a side of the gate spacer.

## Description

### BACKGROUND

In modern society, semiconductor devices are closely related to daily life. In particular, the importance of power semiconductor devices used in various fields such as electric vehicles, railways, electric trams in the field of transportation, renewable energy systems such as solar power generation and wind power generation, and mobile devices is gradually increasing. A power semiconductor device is a semiconductor device used for handling high voltages or high currents, and may perform functions such as power conversion and control in large-scale power systems or high-output electronic devices. A power semiconductor device has the capability and durability to handle high power, may deal with a large amount of current, and may withstand high voltage. For example, a power semiconductor device may handle a voltage of several hundred volts to several thousand volts and a current of several tens of amperes to several thousand amperes. A power semiconductor device may improve the efficiency of electrical energy by minimizing power loss. In addition, the power semiconductor device may be stably operated even in environments such as high temperature.

### SUMMARY

The present disclosure relates to a semiconductor device in which reliability may be improved.

Power semiconductor devices may be classified according to materials being used, such as SiC power semiconductor devices and GaN power semiconductor devices. By manufacturing a power semiconductor device using SiC or GaN instead of conventional silicon (Si), it may be possible to compensate for the drawbacks of silicon having unstable characteristics at high temperatures. The SiC power semiconductor device is resistant to high temperatures and has low power loss, and may be suitable for electric vehicles, renewable energy systems, and the like. GaN power semiconductor devices require high cost but are efficient in terms of speed, and may be suitable for high-speed charging of mobile devices.

In some implementations, a semiconductor device includes a channel layer, a barrier layer positioned on the channel layer and including a material having a different energy band gap from an energy band gap of the channel layer, a gate electrode positioned on the barrier layer, a gate semiconductor layer positioned between the barrier layer and the gate electrode, a gate spacer positioned on opposite sides of the gate semiconductor layer, and source and drain electrodes positioned on opposite sides of the gate electrode and connected to the channel layer. The gate semiconductor layer includes a first pattern portion overlapping the gate electrode and a second pattern portion positioned on opposite sides of the first pattern portion and overlapping the gate spacer, and a side surface of the second pattern portion is aligned with a side surface of the gate spacer.

In some implementations, a semiconductor device includes a channel layer, a barrier layer positioned on the channel layer and including a material having a different energy band gap from an energy band gap of the channel layer, a gate electrode positioned on the barrier layer, a gate semiconductor layer positioned between the barrier layer and the gate electrode, a gate spacer positioned on opposite sides of the gate semiconductor layer, and source and drain electrodes positioned on opposite sides of the gate electrode and connected to the channel layer. The gate semiconductor layer includes a first pattern portion overlapping the gate electrode, and a second pattern portion extending from one side of the first pattern portion and positioned between the gate spacer and the barrier layer, and the width of the second pattern portion is less than the width of the first pattern portion.

In some implementations, a semiconductor device includes a channel layer including GaN, a barrier layer positioned on the channel layer and including AlGaN, a gate electrode positioned on the barrier layer, a hard mask layer positioned on the gate electrode, a gate semiconductor layer positioned between the barrier layer and the gate electrode and including GaN doped with a p-type impurity, a gate spacer positioned on opposite sides of the gate semiconductor layer and positioned on the side surface of the gate electrode and on the side surface of the hard mask layer, a protective layer positioned on the barrier layer, the gate spacer, and the hard mask layer, and a source electrode and a drain electrode positioned on opposite sides of the gate electrode and connected to the channel layer. The gate semiconductor layer includes a first pattern portion overlapping the gate electrode, and a second pattern portion positioned between the gate spacer and the barrier layer. The thickness of the second pattern portion is less than the thickness of the first pattern portion, and the side surface of the second pattern portion is aligned with the side surface of the gate spacer.

According to some implementations, reliability of the semiconductor device may be improved.

At least some of the above and other features of the invention are set out in the claims.

### BRIEF DESCRIPTION OF THE DRAWINGS

FIG. 1 and FIG. 2 are cross-sectional views showing an example of a semiconductor device.
FIG. 3 is an example cross-sectional view enlarging the Q1 region of FIG. 1.
FIGS. 4, 5, 6, 7, 8, 9, 10, 11, and 12 are plan views corresponding to the Q1 region of FIG. 1, illustrating example semiconductor devices.
FIGS. 13, 14, 15, 16, 17, 18A, 18B, and 19 are cross-sectional views illustrating intermediate process steps of an example of a method for manufacturing a semiconductor device.
FIGS. 20, 21, 22, 23, 24A, and 24B are process cross-sectional views of intermediate steps illustrating an example of a method of manufacturing a semiconductor device.

### DETAILED DESCRIPTION

Hereinafter, various implementations of the present disclosure will be described in detail with reference to the accompanying drawings so that those of ordinary skill in the art to which the present disclosure pertains may easily implement the disclosure. The present disclosure may be implemented in various different forms and is not limited to the implementations described herein.

In order to clearly explain the present disclosure, portions irrelevant to the description have been omitted, and throughout the entire specification, the same reference numerals are assigned to identical or similar components.

In addition, the sizes and thicknesses of each component shown in the drawings are arbitrarily depicted for convenience of explanation, and thus the present disclosure is not necessarily limited to what is illustrated. In the drawings, the thickness has been enlarged in order to clearly illustrate multiple layers and regions. Also, in the drawings, for convenience of explanation, the thicknesses of some layers and regions are exaggerated.

In addition, when a layer, film, region, plate, or the like is described as being on or above another portion, this includes not only the case where it is directly on the other portion, but also the case where another portion is interposed therebetween. Conversely, when a certain part is "directly on" another part, it means that there is no other part in between. In addition, stating that it is "on" or "on" a reference part means being positioned above or below the reference part, and does not necessarily mean being positioned "on" or "on" in the direction opposite to gravity.

In addition, throughout the specification, when a certain part is described as "including" a certain component, this means that, unless specifically stated otherwise, it does not exclude other components but may further include other components.

In addition, throughout the specification, when referred to as "in a plan view," this means when the subject portion is viewed from above, and when referred to as "in a cross-sectional view," this means when the subject portion is viewed from the side with a cross-section cut vertically.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The term "overlap" (or "overlapping", or like terms), as may be used herein, is intended to broadly refer to a first element that intersects with at least a portion of a second element when viewed in a particular direction (e.g., in a first direction D1, perpendicular to the upper surface of a substrate). Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers. Features or surfaces that are "aligned" in a particular direction overlap in that direction. Surfaces that are aligned in a particular direction may run parallel to that direction. For instance, two surfaces that are aligned in a particular direction may be positioned such that a line running along the particular direction passes along both surfaces.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

The structure of a semiconductor device shall be described herein with reference to first, second and third directions. The first direction (e.g., X direction) may be a direction parallel to an upper surface of a substrate 110 of the semiconductor device. The second direction (e.g., Y direction) may be a direction parallel to the upper surface of the substrate 110 and that crosses (e.g., that is perpendicular to) the first direction. The third direction (e.g., Z direction) may be a direction that is perpendicular to the upper surface of the substrate 110. As an alternative to defining the directions relative to the upper surface of the substrate 110, the directions may be similarly defined relative to one or more other layers (e.g., an upper surface or lower surface of a channel layer 132 of the semiconductor device). For instance, the third direction may be a thickness direction of the channel layer 132. The third direction may be a height direction (e.g., a vertical direction). Features or elements that are defined as "above" other features or elements may be located further along the third direction than the other features or elements. Similarly, "upper" features or elements may be considered above corresponding "lower" features or elements. It will be appreciated that the positions and directions defined herein are defined relative to the structure of the semiconductor device and therefore need not limit the semiconductor device to user in any particular orientation.

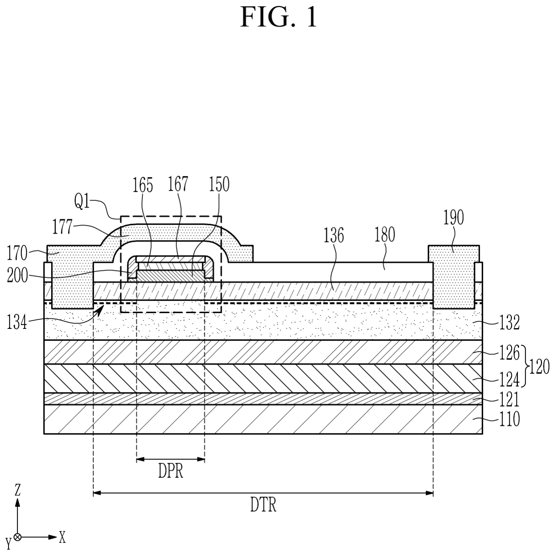

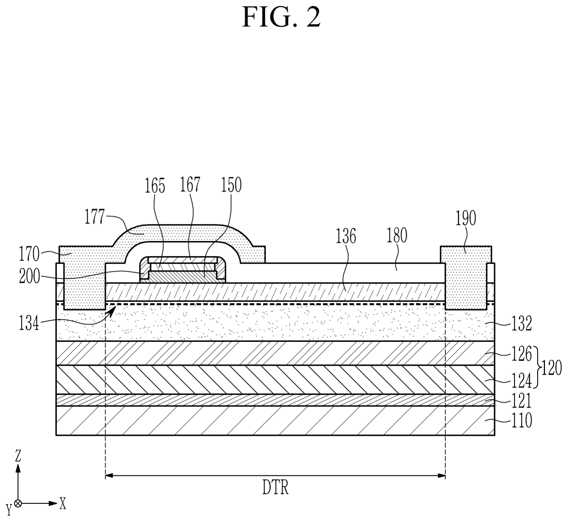

Hereinafter, a semiconductor device will be described with reference to FIG. 1 and FIG. 2.

FIG. 1 and FIG. 2 are cross-sectional views showing an example of a semiconductor device. FIG. 1 illustrates a case where the semiconductor device is in an off state, and FIG. 2 illustrates a case where the semiconductor device is in an on state.

Referring to FIGS. 1 and 2, a semiconductor device includes a channel layer 132, a barrier layer 136 positioned on the channel layer 132, a gate electrode 165 positioned on the barrier layer 136, a gate semiconductor layer 150 positioned between the barrier layer 136 and the gate electrode 165, a gate spacer 200 positioned on opposite sides of the gate semiconductor layer 150, and a source electrode 170 and a drain electrode 190 positioned on opposite sides of the gate electrode 165 and connected (e.g., electrically connected) to the channel layer 132.

The channel layer 132 is a layer configured to form a channel between the source electrode 170 and the drain electrode 190, and a two-dimensional electron gas (2DEG, 2 dimensional electron gas) 134 may be located inside the channel layer 132. The two-dimensional electron gas 134 is a charge transport model used in solid-state physics, and refers to a group of electrons that may move freely in two dimensions (for example, in the x-y plane direction), but are tightly confined within the two-dimensional plane so as not to move in another dimension (for example, the z-direction). That is, the two-dimensional electron gas 134 may exist in a form similar to two-dimensional paper within a three-dimensional space. Such a two-dimensional electron gas 134 mainly appears in a semiconductor heterojunction structure, and in the semiconductor device, may be generated at the interface between the channel layer 132 and the barrier layer 136. For example, a two-dimensional electron gas 134 may be generated in a region adjacent to the barrier layer 136 within the channel layer 132.

The channel layer 132 may include at least one material selected from among nitrides including III-V group materials, for example, Al, Ga, In, B, or combinations thereof. The channel layer 132 may be formed as a single layer or as a multilayer. The channel layer 132 may be AlₓIn_{y}Ga_{1-x-y}N (0≤x≤1, 0≤y≤1, x+y≤1). For example, the channel layer 132 may include AIN, GaN, InN, InGaN, AlGaN, AllnN, AllnGaN, or combinations thereof. The channel layer 132 may be a layer doped with impurities, or may be an undoped layer. The thickness of the channel layer 132 may be about several hundred nm or less.

The channel layer 132 may be positioned on a substrate 110, and a seed layer 121 and a buffer layer 120 may be positioned between the substrate 110 and the channel layer 132. The substrate 110, the seed layer 121, and the buffer layer 120 are layers necessary for forming the channel layer 132, and may be omitted depending on the case. For example, in the case where a substrate made of GaN is used as the channel layer 132, at least one of the substrate 110, the seed layer 121, and the buffer layer 120 may be omitted. In consideration of the relatively high cost of a substrate made of GaN, a substrate 110 made of Si may be used to grow a channel layer 132 including GaN. In this case, due to the difference between the lattice structure of Si and the lattice structure of GaN, it may not be easy to grow the channel layer 132 directly on the substrate 110. Accordingly, a seed layer 121 and a buffer layer 120 may first be grown on the substrate 110, and then the channel layer 132 may be grown on the buffer layer 120. In addition, at least one of the substrate 110, the seed layer 121, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be an SOI (Silicon on Insulator) substrate. However, the material of the substrate 110 is not limited thereto, and any substrate generally used may be applied. In some cases, the substrate 110 may include an insulating material. For example, various layers including a channel layer 132 may first be formed on a semiconductor substrate, after which the semiconductor substrate may be removed and replaced with an insulating substrate.

The seed layer 121 may be positioned directly on the substrate 110. However, example implementations are not limited thereto, and an additional predetermined layer may be positioned between the substrate 110 and the seed layer 121. The seed layer 121 is a layer serving as a seed for growing the buffer layer 120, and may be formed of a crystal lattice structure that serves as the seed of the buffer layer 120. The buffer layer 120 may be positioned directly on the seed layer 121. However, example implementations are not limited thereto, and an additional predetermined layer may be further positioned between the seed layer 121 and the buffer layer 120. The seed layer 121 may include one or more materials selected from among nitride materials including group III-V materials, for example, Al, Ga, In, B, or combinations thereof. The seed layer 121 may be AlₓIn_{y}Ga_{1-x-y}N (0≤x≤1, 0≤y≤1,x+y≤1). For example, the seed layer 121 may include AIN, GaN, InN, InGaN, AlGaN, AlInN, AllnGaN, or combinations thereof.

The buffer layer 120 may be positioned on the seed layer 121. The buffer layer 120 may be positioned between the seed layer 121 and the channel layer 132. The buffer layer 120 may be a layer for alleviating the difference in lattice constant and thermal expansion coefficient between the seed layer 121 and the channel layer 132, or for preventing parasitic current (leakage current) from flowing through the channel layer 132. The buffer layer 120 may include one or more materials selected from among III-V group materials, for example, nitrides including Al, Ga, In, B, or combinations thereof. The buffer layer 120 may be AlₓIn_{y}Ga_{1-x-y}N (0≤x≤1, 0≤y≤1, x+y≤1). For example, the buffer layer 120 may include AIN, GaN, InN, InGaN, AlGaN, AlInN, AlinGaN, or combinations thereof.

The buffer layer 120 of the semiconductor device may include a superlattice layer 124 positioned on the seed layer 121, and a high-resistance layer 126 positioned on the superlattice layer 124. The superlattice layer 124 and the high-resistance layer 126 may be sequentially positioned on the substrate 110.

The superlattice layer 124 may be positioned on the seed layer 121. The superlattice layer 124 may be positioned directly on the seed layer 121. However, example implementations are not limited thereto, and another predetermined layer may be further positioned between the seed layer 121 and the superlattice layer 124. The superlattice layer 124 is a layer for alleviating the difference in lattice constant and thermal expansion coefficient between the substrate 110 and the channel layer 132, thereby mitigating the tensile stress and compressive stress generated between the substrate 110 and the channel layer 132, and for relaxing stress among all layers formed by growth in the final structure of the semiconductor device. The superlattice layer 124 may include one or more materials selected from among nitrides including Group III-V materials, for example, Al, Ga, In, B, or combinations thereof. The superlattice layer 124 may be AlₓIn_{y}Ga_{1-x-y}N (0≤x≤1, 0≤y≤1,x+y≤1). For example, the superlattice layer 124 may include AIN, GaN, InN, InGaN, AlGaN, AlInN, AllnGaN, or a combination thereof.

In some implementations, the superlattice layer 124 may be formed as a multilayer in which layers including different materials are alternately stacked. For example, the superlattice layer 124 may have a structure in which a layer including AlGaN and a layer including AIN are repeatedly laminated. That is, AlGaN/AlN/AlGaN/AlN/AlGaN/AlN may be sequentially stacked to form a superlattice layer. The number of AlGaN layers and GaN constituting the superlattice layer 124 may be variously changed, and the material constituting the superlattice layer 124 may be variously changed. As another example, the superlattice layer 124 may have a structure in which a layer made of AlGaN and a layer made of GaN are repeatedly stacked. That is, AlGaN/GaN/AlGaN/GaN/AlGaN/GaN may be sequentially stacked to form a superlattice layer. In some implementations, when the superlattice layer 124 includes GaN, InN, AlGaN, AllnN, InGaN, AIN, AllnGaN, or a combination thereof, the superlattice layer 124 may have n-type semiconductor characteristics in which the concentration of electrons is greater than the concentration of holes, but example implementations are not limited thereto.

The high-resistance layer 126 may be positioned on the superlattice layer 124. The high-resistance layer 126 may be positioned directly on the superlattice layer 124. However, example implementations are not limited thereto, and an additional predetermined layer may be further positioned between the superlattice layer 124 and the high-resistance layer 126. The high-resistance layer 126 may be positioned between the superlattice layer 124 and the channel layer 132. The high-resistance layer 126 is a layer for preventing the semiconductor device from deteriorating by preventing leakage current from flowing through the channel layer 132. The high-resistance layer 126 may be formed of a material having low conductivity so that the substrate 110 and the channel layer 132 may be electrically insulated from each other. The high resistance layer 126 may be otherwise known as an insulating layer. For instance, the high resistance layer 126 may have a resistivity that is higher than that of silicon. The high resistance layer may include one or more materials selected from among nitrides including Group III-V materials, for example, Al, Ga, In, B, or combinations thereof. The high-resistance layer 126 may be AlₓIn_{y}Ga_{1-x-y}N (0≤x≤1, 0≤y≤1,x+y≤1). For example, the high-resistance layer 126 may include AIN, GaN, InN, InGaN, AlGaN, AllnN, AlInGaN, or combinations thereof. The high-resistance layer 126 may be formed as a single layer or a multilayer.

The barrier layer 136 may be positioned on the channel layer 132. The barrier layer 136 may be positioned directly on the channel layer 132. However, example implementations are not limited thereto, and an additional predetermined layer may be further positioned between the channel layer 132 and the barrier layer 136. A region of the channel layer 132 overlapping the barrier layer 136 between the source electrode 170 and the drain electrode 190 may be a drift region DTR. The drift region DTR may be positioned between the source electrode 170 and the drain electrode 190. The drift region DTR may refer to a region in which carriers move when a potential difference is generated between the source electrode 170 and the drain electrode 190 (e.g., when the semiconductor device is turned on).

The semiconductor device may be turned on or off depending on whether a voltage is applied to the gate electrode 165 and/or the magnitude of the voltage applied to the gate electrode 165, and accordingly, movement of carriers in the drift region DTR may occur or be blocked.

The barrier layer 136 may include one or more materials selected from among III-V group materials, for example, nitrides including Al, Ga, In, B, or combinations thereof. barrier layer 136 may be AlₓIn_{y}Ga_{1-x-y}N (0≤x≤1, 0≤y≤1, x+y≤1). The barrier layer 136 may include GaN, InN, AlGaN, AllnN, InGaN, AlN, AlInGaN, or a combination thereof. The energy band gap of the barrier layer 136 may be controlled by the composition ratio of Al and/or In. The barrier layer 136 may be doped with a predetermined impurity. In this case, the impurity doped into the barrier layer 136 may be a p-type dopant that may provide holes. For example, the impurity doped into the barrier layer 136 may be magnesium (Mg), but example implementations are not limited thereto. By increasing or decreasing the impurity doping concentration of the barrier layer 136, characteristics such as the threshold voltage and on-resistance of the semiconductor device may be controlled.

The barrier layer 136 may include a semiconductor material having characteristics different from those of the channel layer 132. The barrier layer 136 may be different from the channel layer 132 in at least one of polarization characteristic, energy band gap, or lattice constant. For example, the barrier layer 136 may include a material having a different energy band gap from an energy band gap of the channel layer 132. In this case, the barrier layer 136 may have a higher energy band gap than the channel layer 132. In addition, or alternatively the barrier layer 135 may have a higher electric polarizability than the channel layer 132. Through the barrier layer 136, a two-dimensional electron gas 134 may be induced in the channel layer 132 having a relatively low electrical polarizability. In this respect, the barrier layer 136 may also be referred to as a channel supply layer or a two-dimensional electron gas supply layer. The two-dimensional electron gas 134 may be formed in a part of the channel layer 132 positioned below the interface between the channel layer 132 and the barrier layer 136. The two-dimensional electron gas 134 may have very high electron mobility. When considering the relative characteristics (e.g., energy band gaps) of various layers, these characteristics may be considered using fixed measurement conditions, for instance, at the same temperature and pressure (e.g., at room temperature and pressure, such as at 20°C and at 1 atm).

The barrier layer 136 may be formed as a single layer or a multilayer. When the barrier layer 136 is formed of multiple layers, the materials of each layer constituting the multiple layers may have different energy band gaps. In this case, the plurality of layers forming the barrier layer 136 may be arranged such that the energy band gap increases as they are positioned closer to the channel layer 132.

The gate electrode 165 may be positioned on the barrier layer 136. The gate electrode 165 may overlap with a partial region of the barrier layer 136 in the third direction (Z direction). The gate electrode 165 may overlap a portion of the drift region DTR of the channel layer 132 in the third direction (Z direction). The gate electrode 165 may be positioned between the source electrode 170 and the drain electrode 190 (e.g., in the first direction). The gate electrode 165 may be spaced apart from the source electrode 170 and the drain electrode 190 (e.g., in the first direction). For example, the gate electrode 165 may be positioned closer to the source electrode 170 than to the drain electrode 190. That is, the spaced apart distance between the gate electrode 165 and the source electrode 170 may be less than the spaced apart distance between the gate electrode 165 and the drain electrode 190, but example implementations are not limited thereto. In some implementations, the gate electrode 165 may overlap, in a third direction (Z direction), with the field dispersion layer 177 which will be described later. Here, the third direction (Z direction) may refer to the thickness direction and/or the vertical direction of the channel layer 132. A portion of a side surface of the gate electrode 165 may be in contact with the gate spacer 200 to be described later. A side surface of the gate electrode 165 may be covered by the gate spacer 200.

The gate electrode 165 may include a conductive material. For example, the gate electrode 165 may include a metal, a metal alloy, a conductive metal nitride, a metal silicide, a doped semiconductor material, a conductive metal oxide, or a conductive metal oxynitride. For example, the gate electrode 165 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but example implementations are not limited thereto. The gate electrode 165 may be formed of a single layer or a multilayer.

The semiconductor device may further include a hard mask layer 167 positioned on the gate electrode 165.

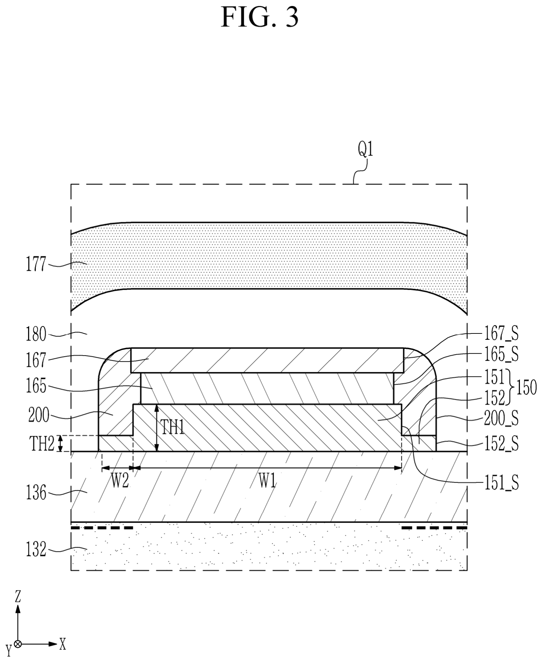

The hard mask layer 167 may be positioned on the upper surface of the gate electrode 165. A lower surface of the hard mask layer 167 may contact the gate electrode 165. The hard mask layer 167 may overlap the gate electrode 165 in the third direction (Z direction). A width of the hard mask layer 167 in the first direction (X direction) may be equal to or greater than a width of the gate electrode 165 in the first direction (X direction). A side surface 167_S (see FIG. 3) of the hard mask layer 167 may be positioned adjacent to (e.g., closer to) the source electrode 170 compared to the side surface 165_S (see FIG. 3) of the gate electrode 165. That is, the distance between the hard mask layer 167 and the source electrode 170 may be less than or equal to the distance between the gate electrode 165 and the source electrode 170, but example implementations are not limited thereto. Similarly, on an opposite side of the hard mask layer 167 and the gate electrode, the distance the distance between the hard mask layer 167 and the drain electrode 190 may be less than or equal to the distance between the gate electrode 165 and the drain electrode 190, but example implementations are not limited thereto. The side surface 167_S (see FIG. 3) of the hard mask layer 167 may be misaligned with the side surface 165_S (see FIG. 3) of the gate electrode 165 in the third direction (Z direction), but example implementations are not limited thereto. In some implementations, the side surface 167_S (see FIG. 3) of the hard mask layer 167 may be aligned with the side surface 165_S (see FIG. 3) of the gate electrode 165 in the third direction (Z direction).

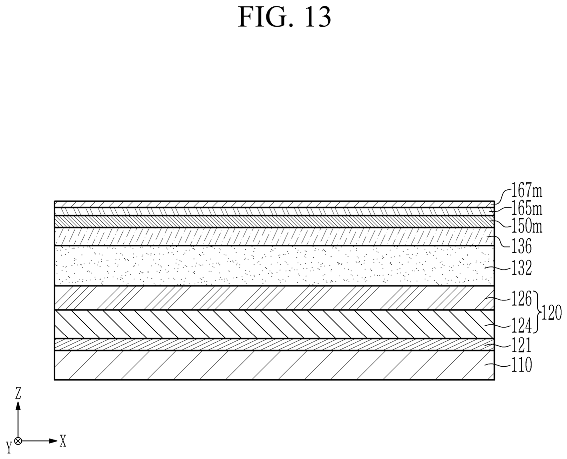

The hard mask layer 167 may be a hard mask used when patterning the gate electrode material layer 165m (see FIG. 13) and/or the gate semiconductor material layer 150m (see FIG. 13) in the process of forming the gate electrode 165. The hard mask layer 167 may include SiO₂, SiN, SiON, or a combination thereof. However, example implementations are not limited thereto, and the hard mask layer 167 may be removed depending on the etching conditions during etching of the gate electrode material layer 165m (see FIG. 13) and/or the gate semiconductor material layer 150m (see FIG. 13), or according to the cleaning conditions after etching.

The gate semiconductor layer 150 may be positioned between the barrier layer 136 and the gate electrode 165. That is, a gate semiconductor layer 150 may be positioned on the barrier layer 136, and a gate electrode 165 may be positioned on the gate semiconductor layer 150. The gate electrode 165 may be in Schottky contact or ohmic contact with the gate semiconductor layer 150. The gate semiconductor layer 150 may overlap the gate electrode 165 in the third direction (Z direction).

The gate semiconductor layer 150 may be positioned between the source electrode 170 and the drain electrode 190 (e.g., in the first direction). The gate semiconductor layer 150 may be spaced apart from the source electrode 170 and the drain electrode 190 (e.g., in the first direction). The gate semiconductor layer 150 may be positioned closer to the source electrode 170 than to the drain electrode 190. That is, the spaced apart distance between the gate semiconductor layer 150 and the source electrode 170 may be less than the spaced apart distance between the gate semiconductor layer 150 and the drain electrode 190, but example implementations are not limited thereto.

The gate semiconductor layer 150 may include one or more materials selected from among group III-V nitrides including Al, Ga, In, B, or combinations thereof. The gate semiconductor layer 150 may be AlₓIn_{y}Ga_{1-x-y}N (0≤x≤1, 0≤y≤1, x+y≤1). For example, the gate semiconductor layer 150 may include AIN, GaN, InN, InGaN, AlGaN, AlInN, AllnGaN, or a combination thereof. The gate semiconductor layer 150 may include a material having an energy band gap different from that of the barrier layer 136. For example, the gate semiconductor layer 150 may include GaN, and the barrier layer 136 may include AlGaN. The gate semiconductor layer 150 may be doped with a predetermined impurity. In this case, the impurity doped into the gate semiconductor layer 150 may be a p-type dopant capable of providing a hole. For example, the gate semiconductor layer 150 may include GaN in which a p-type impurity is doped. That is, the gate semiconductor layer 150 may be formed of a p-GaN layer. However, example implementations are not limited thereto, and the gate semiconductor layer 150 may be a p-AlGaN layer.

The gate semiconductor layer 150 may include a part overlapping the gate electrode 165 in the third direction (Z direction) and a part overlapping the gate spacer 200, which will be described later, in the third direction (Z direction). The portion of the gate semiconductor layer 150 overlapping with the gate electrode 165 in the third direction (Z direction) may be referred to as the first pattern portion 151 (see FIG. 3), and the portion overlapping with the gate spacer 200 in the third direction (Z direction) may be referred to as the second pattern portion 152 (see FIG. 3). A detailed description thereof will be provided below with reference to FIG. 3.

A depletion region DPR may be formed in the channel layer 132 by the gate semiconductor layer 150. The depletion region DPR may be located within the drift region DTR, and may have a width narrower than the drift region DTR. A gate semiconductor layer 150 having an energy band gap different from that of the barrier layer 136 is positioned on the barrier layer 136, so that the energy band level (e.g., the conduction band level) of a portion of the barrier layer 136 overlapping with a portion of the gate semiconductor layer 150 (for example, a first pattern portion 151 of the gate semiconductor layer 150) may be increased. Accordingly, a depletion region DPR may be formed in a region of the channel layer 132 overlapping a portion for example, the first pattern portion 151 (see FIG. 3) of the gate semiconductor layer 150. The depletion region DPR may be a region among the channel path of the channel layer 132, in which the two-dimensional electron gas 134 is not formed or a region having a lower electron concentration than other regions. That is, the depletion region DPR may refer to a region in the drift region DTR in which the flow of the two-dimensional electron gas 134 is interrupted. As the depletion region DPR is generated, current may not flow between the source electrode 170 and the drain electrode 190, and the channel path may be blocked. Accordingly, the semiconductor device may have a normally off characteristic (e.g., the semiconductor device may be off when no voltage is applied to the gate).

The semiconductor device may be a field effect transistor (FET). The semiconductor device may be a high electron mobility transistor (HEMT). A HEMT may be a FET whose operational channel is formed by a two-dimensional electron gas (2DEG) confined at the interface of a heterojunction formed between two semiconductor materials with different bandgaps. The 2DEG may be supplied by dopants in the wider-bandgap material (e.g., in the barrier layer). The channel layer may be undoped. The semiconductor device may be a normally off HEMT. As shown in FIG. 1, in a normal state in which no voltage is applied to the gate electrode 165, a depletion region DPR exists, and the semiconductor device may be in an off state. As shown in FIG. 2, when a voltage equal to or greater than the threshold voltage is applied to the gate electrode 165, the depletion region DPR disappears, and the two-dimensional electron gas 134 within the drift region DTR may be continuously connected without interruption. That is, a two-dimensional electron gas 134 may be formed over the entire channel path between the source electrode 170 and the drain electrode 190, and the semiconductor device may be in an on state. In summary, a semiconductor device may include semiconductor layers having different electrical polarization properties, and a semiconductor layer having a relatively high degree of polarization may induce a two-dimensional electron gas 134 in another semiconductor layer heterojunctioned therewith. Such two-dimensional electron gas 134 may be used as a channel between the source electrode 170 and the drain electrode 190, and the continuity or interruption of the flow of the two-dimensional electron gas 134 may be controlled by a bias voltage applied to the gate electrode 165. In a gate-off state, the flow of the two-dimensional electron gas 134 is blocked, so that current may not flow between the source electrode 170 and the drain electrode 190. As the flow of the two-dimensional electron gas 134 continues in the gate-on state, current may flow between the source electrode 170 and the drain electrode 190.

The previously described seed layer 121, superlattice layer 124, high-resistance layer 126, channel layer 132, and barrier layer 136 may be sequentially stacked on the substrate 110. In the semiconductor device, at least one of the seed layer 121, the superlattice layer 124, the high-resistance layer 126, the channel layer 132, and the barrier layer 136 may be omitted. These seed layer 121, superlattice layer 124, and high-resistance layer 126 may be formed of a semiconductor material of the same base, and the material composition ratio of each layer may be different in consideration of the role of each layer and performance required by the semiconductor device.

The gate spacer 200 may be positioned at at least one side of the gate semiconductor layer 150. For example, the gate spacer 200 may be positioned on opposite sides of the gate semiconductor layer 150 in the first direction (X direction). The gate spacer 200 may cover at least a portion of a side surface of the gate semiconductor layer 150. The gate spacer 200 may be in contact with at least a part of a side surface of the gate semiconductor layer 150, but example implementations are not limited thereto.

In addition, the gate spacer 200 may be positioned on at least one side of the gate electrode 165. For example, the gate spacer 200 may be positioned on opposite sides of the gate electrode 165 in the first direction (X direction). The gate spacer 200 may be positioned on opposite side surfaces of the gate electrode 165. The gate spacer 200 may cover at least a portion of a side surface of the gate electrode 165. The gate spacer 200 may contact the side surface of the gate electrode 165, but example implementations are not limited thereto. In addition, the gate spacer 200 may be positioned on the side surface of the hard mask layer 167. The gate spacer 200 may be positioned on opposite side surfaces of the hard mask layer 167. The gate spacer 200 may cover at least a portion of the side surface of the hard mask layer 167. The gate spacer 200 may contact at least a portion of the side surface of the hard mask layer 167, but example implementations are not limited thereto.

The gate spacer 200 may be positioned on the gate semiconductor layer 150. For example, the gate spacer 200 may be positioned on opposite sides of the first pattern portion 151 (see FIG. 3) in the first direction (X direction) of the gate semiconductor layer 150 over the second pattern portion 152 (see FIG. 3). The gate spacer 200 may be positioned between the gate semiconductor layer 150 and the protective layer 180, which will be described later. The gate spacer 200 may be covered by the protective layer 180 which will be described later.

A side surface of the gate spacer 200 may be aligned with a side surface of the gate semiconductor layer 150. The side surface of the gate spacer 200 may be aligned with one end of the gate semiconductor layer 150 in the third direction (Z direction). This may be attributable to the process characteristic of patterning the gate semiconductor layer 150 using the gate spacer 200 as a mask. A description thereof will be given below with reference to FIG. 3.

The gate spacer 200 may include a convex curved surface. For example, the side surface of the gate spacer 200 may have a convex curved shape in a direction away from an upper surface of the channel layer 132, but example implementations are not limited thereto. A width of the gate spacer 200 in the first direction (X direction) may decrease with increasing distance from the upper surface of the channel layer 132. That is, the width in the first direction (X direction) of the gate spacer 200 portion adjacent to the barrier layer 136 may be greater than the width of the gate spacer 200 portion adjacent to the gate electrode 165 and/or the hard mask layer 167 in the first direction (X direction), but example implementations are not limited thereto.

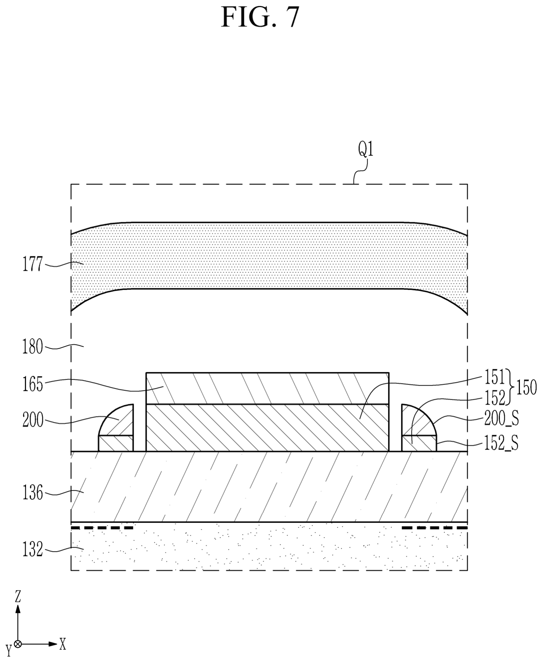

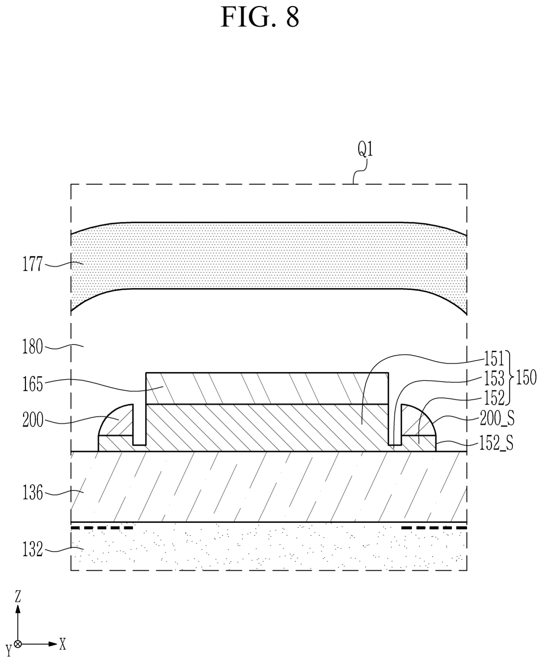

The upper surface of the gate spacer 200 may be positioned at a higher level or at substantially the same level as the upper surface of the gate electrode 165. A distance between the upper surface of the gate spacer 200 and the upper surface of the channel layer 132 may be greater than or equal to a distance between the upper surface of the gate electrode 165 and the upper surface of the channel layer 132. The upper surface of the gate spacer 200 may be positioned at a lower level than or at substantially the same level as the upper surface of the hard mask layer 167. A distance between the upper surface of the gate spacer 200 and the upper surface of the channel layer 132 may be less than or equal to a distance between the upper surface of the hard mask layer 167 and the upper surface of the channel layer 132. However, example implementations are not limited thereto, and the upper surface of the gate spacer 200 may be positioned at a level lower than the upper surface of the gate electrode 165. Description thereof will be given later with reference to FIG. 7 and FIG. 8.

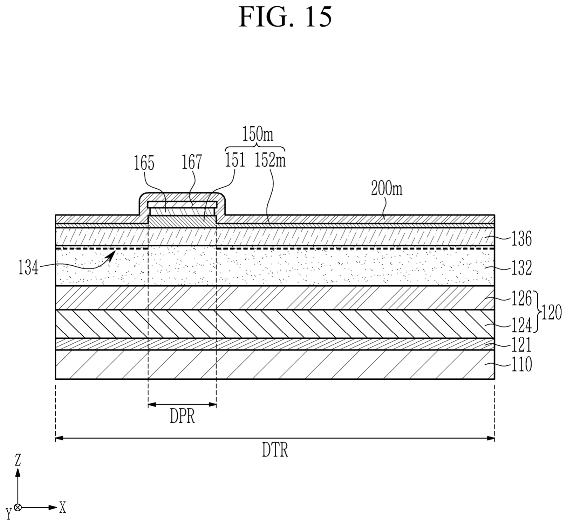

A semiconductor device may include a plurality of gate spacers 200 positioned on opposite sides of a gate semiconductor layer 150 in a first direction (X direction), and the plurality of gate spacers 200 may have shapes that are symmetrical to each other. For example, the plurality of gate spacers 200 may have a mirror-symmetric shape with respect to the third direction (Z direction). The axis of symmetry may be located half way between the gate spacers 200. Here, the third direction (Z direction) may refer to the thickness direction and/or the vertical direction of the channel layer 132. This may be due to the process characteristics in which a gate spacer material layer 200m (see FIG. 15) is formed on the gate semiconductor material layer 150m (see FIG. 15), and the gate spacer 200 is formed using an etch-back process.

The gate spacer 200 may include an insulating material. For example, the gate spacer 200 may include SiO₂. As another example, the gate spacer 200 may include an oxide such as Al₂O₃, or a silicate carbide such as SiOC.

The semiconductor device may further include a protective layer 180 positioned on the barrier layer 136.

The protective layer 180 may be positioned on the barrier layer 136 and the gate electrode 165. The protective layer 180 may be positioned on the gate spacer 200. The protective layer 180 may cover the barrier layer 136, the hard mask layer 167, and the gate spacer 200. For example, the protective layer 180 may cover the upper surface of the barrier layer 136, the upper surface of the hard mask layer 167, and the gate spacer 200. The protective layer 180 may be positioned conformally on the upper surface of the barrier layer 136, the upper surface of the hard mask layer 167, and on the gate spacer 200. A lower surface of the protective layer 180 may contact an upper surface of the barrier layer 136, an upper surface of the hard mask layer 167, and the gate spacer 200. The protective layer 180 may cover a portion of the side surface of the gate semiconductor layer 150. The protective layer 180 may be in contact with at least a portion of the side surface of the gate semiconductor layer 150, but example implementations are not limited thereto.

The protective layer 180 may include one or more materials selected from group III-V nitride materials including Al, Ga, In, B, or combinations thereof. For example, the protective layer 180 may include SiO₂. As another example, the protective layer 180 may include an oxide such as Al₂O₃ or a carbonated oxide such as SiOC.

In FIG. 1 and FIG. 2, the protective layer 180 is illustrated as being formed of a single layer, but this is not limited thereto. For example, the protective layer 180 may be formed of multiple layers (e.g., two or more layers).

The source electrode 170 and the drain electrode 190 may be positioned on the channel layer 132. The source electrode 170 and the drain electrode 190 may be in direct contact with the channel layer 132, and may be electrically connected to the channel layer 132.

The source electrode 170 and the drain electrode 190 may extend in the second direction (Y direction). The source electrode 170 and the drain electrode 190 may be spaced apart from each other (e.g., in the first direction), and the gate electrode 165, hard mask layer 167, and gate semiconductor layer 150 may be positioned between the source electrode 170 and the drain electrode 190. The gate electrode 165, the hard mask layer 167, and the gate semiconductor layer 150 may be spaced apart from the source electrode 170 and the drain electrode 190. For example, the source electrode 170 may be electrically connected to the channel layer 132 at one side of the gate electrode 165, and the drain electrode 190 may be electrically connected to the channel layer 132 at the other side of the gate electrode 165. The source electrode 170 and the drain electrode 190 may be positioned on the outside of the drift region DTR of the channel layer 132. The interface between the source electrode 170 and the channel layer 132 may be one edge of the drift region DTR. Likewise, the interface between the drain electrode 190 and the channel layer 132 may be the other edge of the drift region DTR.

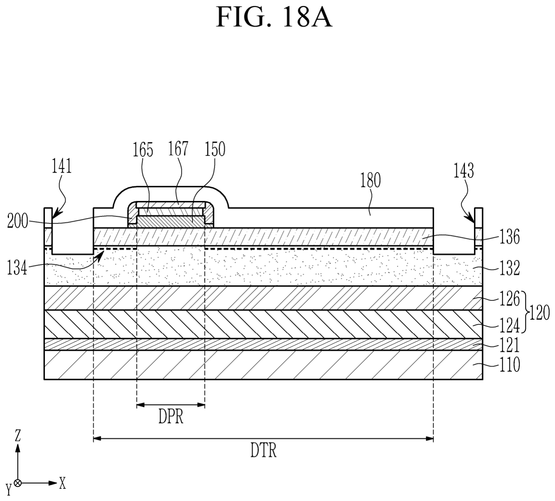

The source electrode 170 and the drain electrode 190 may be positioned in a trench recessing the upper surface of the channel layer 132. Specifically, trenches 141, 143 (see FIG. 18A) passing through the protective layer 180 and the barrier layer 136, and recessing an upper surface of the channel layer 132, may be positioned such that they are spaced apart from each other on opposite sides of the gate electrode 165. The source electrode 170 and the drain electrode 190 may be positioned in trenches 141, 143 (see FIG. 18A) positioned at opposite sides of the gate electrode 165, respectively. The source electrode 170 and the drain electrode 190 may be formed to fill the trenches 141, 143 (see FIG. 18A). The source electrode 170 and drain electrode 190 within the trenches 141, 143 (see FIG. 18A) may be in contact with the channel layer 132 and barrier layer 136. The channel layer 132 may form bottom surfaces and sidewalls of trenches 141, 143 (see FIG. 18A), and the barrier layer 136 may form sidewalls of the trenches 141, 143 (see FIG. 18A). Therefore, the source electrode 170 and the drain electrode 190 may be in contact with the upper surface and a side surface of the channel layer 132. In addition, the source electrode 170 and the drain electrode 190 may be in contact with the side surface of the barrier layer 136. The source electrode 170 and the drain electrode 190 may cover a side surface of the channel layer 132 and a side surface of the barrier layer 136. However, example implementations are not limited thereto, and the channel layer 132 may not be recessed, and the source electrode 170 and the drain electrode 190 may be in contact with the channel layer 132.

In some implementations, upper surfaces of the source electrode 170 and the drain electrode 190 may protrude beyond an upper surface of the protective layer 180. The source electrode 170 and the drain electrode 190 may cover at least a portion of a side surface of the protective layer 180. For example, the source electrode 170 and the drain electrode 190 may cover a portion of a side surface of the protective layer 180, and may not cover the remaining portion of the side surface of the protective layer 180. In this case, a remaining portion of the protective layer 180 may be positioned on the upper surface of the source electrode 170 and the drain electrode 190.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal oxynitride. For example, the source electrode 170 and the drain electrode 190 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but example implementations are not limited thereto. The source electrode 170 and the drain electrode 190 may be formed of a single layer or a multilayer. The source electrode 170 and the drain electrode 190 may be in ohmic contact with the channel layer 132. The region of the channel layer 132 in contact with the source electrode 170 and the drain electrode 190 may be doped at a relatively high concentration compared to other regions.

In FIG. 1 and FIG. 2, the semiconductor device is illustrated as including a pair of source electrodes 170 and drain electrodes 190, but the number of the source electrodes 170 and drain electrodes 190 is not limited thereto. For example, the source electrode 170 may include a plurality of source electrodes sequentially stacked on the channel layer 132 in a third direction (Z direction), and the drain electrode 190 may also include a plurality of drain electrodes sequentially stacked on the channel layer 132 in the third direction (Z direction).

A semiconductor device may further include a field dispersion layer 177 positioned on the protective layer 180.

The field dispersion layer 177 may be positioned between the source electrode 170 and the drain electrode 190. The field dispersion layer 177 may be positioned on the barrier layer 136. The field dispersion layer 177 may overlap the channel layer 132 in the third direction (Z direction). In some implementations, the field dispersion layer 177 may overlap the gate electrode 165 and the gate semiconductor layer 150 in the third direction (Z direction). The field dispersion layer 177 may overlap with the gate spacer 200 in the third direction (Z direction).

The field dispersion layer 177 may be connected to the source electrode 170. The field dispersion layer 177 may extend from one side of the source electrode 170 toward the drain electrode 190. One end of the field dispersion layer 177 may be positioned closer to the drain electrode 190 than one end of the gate spacer 200. The distance in the first direction (X direction) between a side surface of the field dispersion layer 177 and the drain electrode 190 may be less than the distance in the first direction (X direction) between a side surface of the gate spacer 200 and the drain electrode 190. In addition, one end of the field dispersion layer 177 may be positioned closer to the drain electrode 190 than one end of the gate semiconductor layer 150. The distance in the first direction (X direction) between a side surface of the field dispersion layer 177 and the drain electrode 190 may be less than the distance in the first direction (X direction) between a side surface of the gate semiconductor layer 150 and the drain electrode 190.

The field dispersion layer 177 may include the same material as the source electrode 170. The field dispersion layer 177 may include a conductive material. For example, the field dispersion layer 177 may include a metal, metal alloy, conductive metal nitride, metal silicide, doped semiconductor material, conductive metal oxide, or conductive metal oxynitride. The field dispersion layer 177 may be formed simultaneously in the same process as the source electrode 170. The field dispersion layer 177 may be integrally formed with the source electrode 170. However, example implementations are not limited thereto, and the field dispersion layer 177 may be positioned on a layer different from the source electrode 170, and may be formed in a different process.

The field dispersion layer 177 may serve to disperse an electric field concentrated around the gate electrode 165. Specifically, in the gate-off state, a portion of the channel layer 132 positioned between the gate electrode 165 and the source electrode 170, and a portion of the channel layer 132 positioned between the gate electrode 165 and the drain electrode 190, may have the two-dimensional electron gas 134 positioned at a very high concentration. In this case, an electric field may be concentrated on the gate electrode 165 or the gate semiconductor layer 150. On the other hand, the gate electrode 165 and the gate semiconductor layer 150 are vulnerable to electric fields, and when the electric field is concentrated, the leakage current may increase and the breakdown voltage of the semiconductor device may decrease. The semiconductor device may have a field dispersion layer 177 in which the electric field concentrated around the gate electrode 165 or the gate semiconductor layer 150 is dispersed, thereby reducing leakage current and increasing breakdown voltage.

In some implementations, the number of field dispersion layers 177 may be variously changed. For example, the field dispersion layer 177 may include a plurality of field dispersion layers positioned on the protective layer 180.

Hereinafter, the gate semiconductor layer 150 of the semiconductor device will be described with further reference to FIG. 3.

FIG. 3 is an example enlarged cross-sectional view of the Q1 region of FIG. 1.

Referring further to FIG. 3, the gate semiconductor layer 150 of the semiconductor device may include a first pattern portion 151 overlapping the gate electrode 165 in the third direction (Z direction) and a second pattern portion 152 overlapping the gate spacer 200 in the third direction (Z direction).

The first pattern portion 151 may be positioned on the barrier layer 136. The first pattern portion 151 may be positioned between the barrier layer 136 and the gate electrode 165. The first pattern portion 151 may overlap the gate electrode 165, the hard mask layer 167, and the field dispersion layer 177 in the third direction (Z direction). At least a portion of the first pattern portion 151 may overlap with the gate spacer 200 in the third direction (Z direction), but example implementations are not limited thereto. A lower surface of the first pattern portion 151 may contact the barrier layer 136. An upper surface of the first pattern portion 151 may contact the gate electrode 165. End portions on opposite sides of the first pattern portion 151 may be in contact with the gate spacer 200, but example implementations are not limited thereto.

A side surface 151_S of the first pattern portion 151 may contact the gate spacer 200. The side surface 151_S of the first pattern portion 151 may be aligned with the side surface 167_S of the hard mask layer 167 in the third direction (Z direction), but example implementations are not limited thereto. The side surface 151_S of the first pattern portion 151 may not be aligned with the side surface 165_S of the gate electrode 165 in the third direction (Z direction); however, example implementations are not limited thereto. Accordingly, the first pattern portion 151 may be spaced apart from the protective layer 180. However, example implementations are not limited thereto, and the side surface 151_S of the first pattern portion 151 may be in contact with the protective layer 180. A description relating thereto will be provided below with reference to FIG. 7 and FIG. 8.

The first pattern portion 151 may have a first thickness TH1 in the third direction (Z direction). The first thickness TH1 of the first pattern portion 151 may be about 30 nm to about 150 nm, but example implementations are not limited thereto. For instance, the first thickness TH1 may be greater than or equal to 30 nm and less then or equal to 150 nm. The first pattern portion 151 may have a first width W1 in the first direction (X direction). The first width W1 of the first pattern portion 151 may be substantially the same as the width of the hard mask layer 167 in the first direction (X direction), but example implementations are not limited thereto. For example, the first width W1 of the first pattern portion 151 may be greater than or less than the width of the hard mask layer 167 in the first direction (X direction). The first width W1 of the first pattern portion 151 may be greater than or equal to the width of the gate electrode 165 in the first direction (X direction). The first width W1 of the first pattern portion 151 may be about 0.2 µm to about 2 µm, but example implementations are not limited thereto. For instance, the first width W1 of the first pattern portion 151 may be greater than or equal to 0.2 µm and less than or equal to 2 µm.

The second pattern portion 152 may be positioned on the barrier layer 136. The second pattern portion 152 may be positioned between the barrier layer 136 and the gate spacer 200. The second pattern portion 152 may overlap the gate spacer 200 in the third direction (Z direction). The second pattern portion 152 may completely overlap with the gate spacer 200 in the third direction (Z direction), but example implementations are not limited thereto. The second pattern portion 152 may be non-overlapping with the gate electrode 165 and the hard mask layer 167 in the third direction (Z direction), but example implementations are not limited thereto. For example, at least a portion of the second pattern portion 152 may overlap with the gate electrode 165 and/or the hard mask layer 167 in the third direction (Z direction). The second pattern portion 152 may overlap the field dispersion layer 177 in the third direction (Z direction). A lower surface of the second pattern portion 152 may be in contact with the barrier layer 136, and an upper surface of the second pattern portion 152 may be in contact with the gate spacer 200. For example, the entire upper surface of the second pattern portion 152 may contact the gate spacer 200, but example implementations are not limited thereto.

The second pattern portion 152 may extend from at least one side of the first pattern portion 151. For example, the second pattern portion 152 may extend in the first direction (X direction) from opposite sides of the second pattern portion 152. The second pattern portion 152 may protrude from opposite sides of the first pattern portion 151.

A side surface 152_S of the second pattern portion 152 may be aligned with a side surface 200_S of the gate spacer 200. For example, at least a portion of the side surface 152_S of the second pattern portion 152 may be aligned with the side surface 200_S of the gate spacer 200 in a third direction (Z direction). The distance in the first direction (X direction) between the side surface 152_S of the second pattern portion 152 and the drain electrode 190 may be substantially the same as the distance in the first direction (X direction) between the side surface 200_S of the gate spacer 200 and the drain electrode 190. Similarly, the distance in the first direction (X direction) between the side surface 152_S of the second pattern portion 152 and the source electrode 170 may be substantially the same as the distance in the first direction (X direction) between the side surface 200_S of the gate spacer 200 and the source electrode 170. This may be due to the process characteristics of forming the second pattern portion 152 using the gate spacer 200 as a mask.

The distance in the first direction (X direction) between the second pattern portion 152 and the drain electrode 190 may be greater than the distance in the first direction (X direction) between the field dispersion layer 177 and the drain electrode 190. The distance in the first direction (X direction) between the side surface 152_S of the second pattern portion 152 facing the drain electrode 190 and the side surface of the drain electrode 190 may be greater than the distance between the side surface of the field dispersion layer 177 and the side surface of the drain electrode 190. Within this range, the second pattern portion 152 may effectively prevent an electric field from being concentrated on the gate electrode 165.

The second pattern portion 152 may have a second thickness TH2 in a third direction (Z direction). The second thickness TH2 of the second pattern portion 152 may be less than the first thickness TH1 of the first pattern portion 151. For example, the second thickness TH2 of the second pattern portion 152 may be about 1/50 to about 1/2 of the first thickness TH1 of the first pattern portion 151. Preferably, the second thickness TH2 of the second pattern portion 152 may be about 1/10 to about 1/5 of the first thickness TH1 of the first pattern portion 151. When the second thickness TH2 of the second pattern portion 152 is less than 1/50 (preferably 1/10) of the first thickness TH1 of the first pattern portion 151, the second pattern portion 152 may have a weakened function of dispersing the electric field concentrated around the gate electrode 165. When the second thickness TH2 of the second pattern portion 152 is greater than 1/2 (preferably 1/5) of the first thickness TH1 of the first pattern portion 151, the concentration of the two-dimensional electron gas 134 in a portion of the channel layer 132 overlapping the second pattern portion 152 and the second pattern portion 152 in the third direction (Z direction) may decrease. Accordingly, the channel resistance of the semiconductor device may increase, and the characteristics of the semiconductor device may deteriorate. In this range, the second thickness TH2 of the second pattern portion 152 may be about 3 nm to about 30 nm; however, it is not limited thereto. Accordingly, the gate semiconductor layer 150 may have a step at a portion where the first pattern portion 151 and the second pattern portion 152 meet.

The second pattern portion 152 may have a second width W2 in the first direction (X direction). The second width W2 of the second pattern portion 152 may be less than the first width W1 of the first pattern portion 151. For example, the second width W2 of the second pattern portion 152 may be about 3/200 to about 1/2 of the first width W1 of the first pattern portion 151. Preferably, the second width W2 of the second pattern portion 152 may be about 1/10 to about 1/5 of the first width W1 of the first pattern portion 151. When the second width W2 of the second pattern portion 152 is less than 3/200 (preferably 1/10) of the first width W1 of the first pattern portion 151, the second pattern portion 152 may have a reduced function of dispersing the electric field concentrated around the gate electrode 165. When a second width W2 of the second pattern portion 152 is greater than 1/2 (preferably 1/5) of a first width W1 of the first pattern portion 151, since a region where the second pattern portion 152 and the barrier layer 136 are overlapping in a third direction (Z direction) increases, a concentration of the two-dimensional electron gas 134 in a portion of the channel layer 132 which is overlapping with the second pattern portion 152 and in the third direction (Z direction) may decrease. Accordingly, the channel resistance of the semiconductor device may increase, and the characteristics of the semiconductor device may deteriorate. In this range, the second thickness TH2 of the second pattern portion 152 may be about 0.03 µm to about 0.3 µm; however, it is not limited thereto.

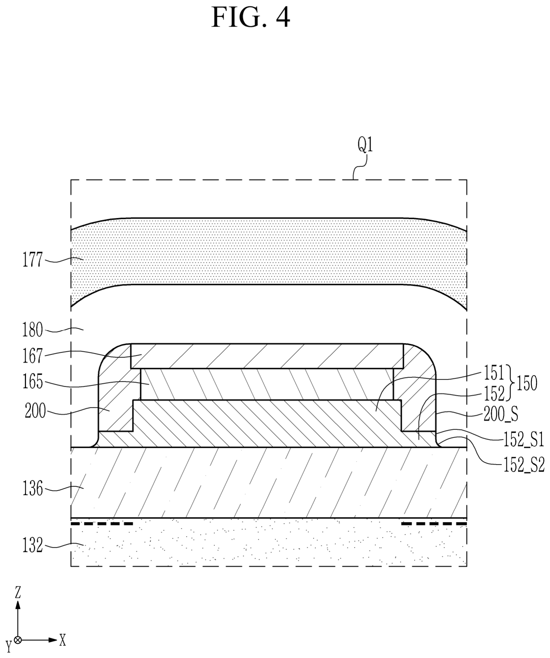

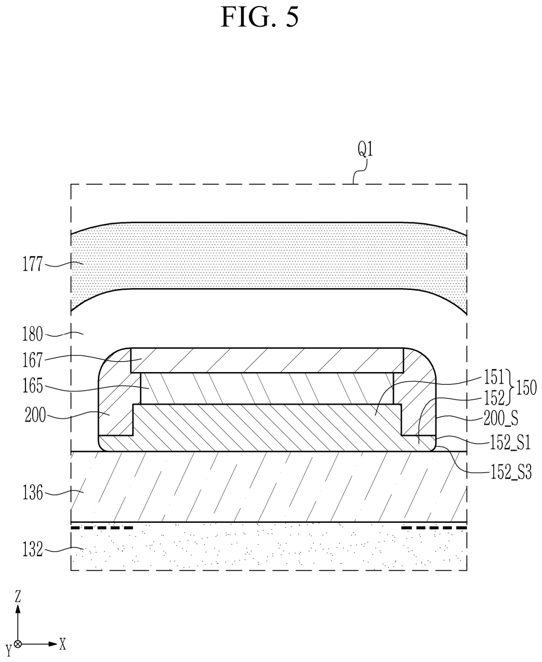

The second width W2 of the second pattern portion 152 may be less than the width of the hard mask layer 167 in the first direction (X direction). The second width W2 of the second pattern portion 152 may be less than the width of the gate electrode 165 in the first direction (X direction). The second width W2 of the second pattern portion 152 may be less than or equal to the maximum width of the gate spacer 200 in the first direction (X direction). The second width W2 of the second pattern portion 152 may be uniform, but example implementations are not limited thereto. For example, the second pattern portion 152 may include a portion in which the width in the first direction (X direction) decreases with increasing distance from the upper surface of the barrier layer 136. As another example, the second pattern portion 152 may include a portion in which the width in the first direction (X direction) increases with increasing distance from the upper surface of the barrier layer 136. A description thereof will be provided below with reference to FIG. 4 and FIG. 5.

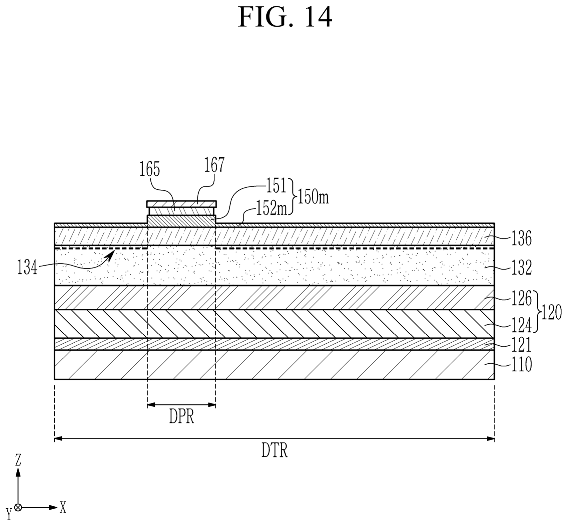

The second pattern portion 152 may be at least a part of the second preliminary pattern portion 152m (see FIG. 14), which protects the barrier layer 136 and/or the channel layer 132 in the process of forming the gate spacer 200. Specifically, after forming a gate spacer material layer 200m (see FIG. 15) on the second preliminary pattern portion 152m (see FIG. 14), the gate spacer material layer 200m (see FIG. 15) may be etched to form a gate spacer 200. In this case, since the barrier layer 136 is covered by the second preliminary pattern portion 152m (see FIG. 14), it may be possible to prevent the barrier layer 136 and/or the channel layer 132 from being damaged by the etching gas and/or etching solution during the process of etching the gate spacer material layer 200m (see FIG. 15). Subsequently, the second preliminary pattern portion 152m (see FIG. 14) may be patterned to form the second pattern portion 152.

In some implementations, gate spacers 200 may be positioned on opposite sides of the first pattern portion 151 over the second pattern portion 152. Each gate spacer 200 may contact the upper surface of the second pattern portion 152 and a corresponding side surface 151_S of the first pattern portion 151.

The gate semiconductor layer 150 of the semiconductor device may include a first pattern portion 151 and a second pattern portion 152 extending in a first direction (X direction) from at least one side of the first pattern portion 151. The second thickness TH2 of the second pattern portion 152 may be less than the first thickness TH1 of the first pattern portion 151, and the second width W2 of the second pattern portion 152 may be less than the first width W1 of the first pattern portion 151. Accordingly, the second pattern portion 152 may prevent an increase in channel resistance and, at the same time, may effectively disperse the electric field concentrated around the gate electrode 165. Accordingly, the leakage current of the semiconductor device may be reduced, and the breakdown voltage may be increased.

Hereinafter, the semiconductor device according to several implementations will be described with reference to FIGS. 4 to 12.

FIGS. 4, 5, 6, 7, 8, 9, 10, 11, and 12 are plan views corresponding to the Q1 region of FIG. 1, showing example semiconductor devices.

FIGS. 4 to 12 illustrate various modifications of a semiconductor device shown in FIGS. 1 to 3. FIGS. 4 to 12 illustrate implementations in which the parts corresponding to those of the implementations shown in FIGS. 1 to 3 are substantially identical, and thus, descriptions thereof will be omitted and differences will be mainly described. In addition, the same drawing reference numerals are used for components identical to those in the previous implementation.

Referring to FIGS. 4 and 5, the second pattern portion 152 of the semiconductor device may have various shapes.

For example, as shown in FIG. 4, the width of the second pattern portion 152 in the first direction (X direction) may include a portion that decreases with increasing distance from the upper surface of the barrier layer 136. A side surface of the second pattern portion 152 may include a first side surface 152_S1 aligned with a side surface 200_S of the gate spacer 200 in a third direction (Z direction), and a second side surface 152_S2 positioned between the first side surface 152_S1 and an upper surface of the barrier layer 136. The first side surface 152_S1 may extend in the third direction (Z direction). The second side surface 152_S2 may be concave toward the upper surface of the barrier layer 136, but example implementations are not limited thereto. The second side surface 152_S2 may be an inclined surface sloped from the upper surface of the barrier layer 136.

As another example, as shown in FIG. 5, the width of the second pattern portion 152 in the first direction (X direction) may include a portion that increases with increasing distance from the upper surface of the barrier layer 136. A side surface of the second pattern portion 152 may include a first side surface 152_S1 aligned with a side surface 200_S of the gate spacer 200 in the third direction (Z direction) and a third side surface 152_S3 positioned between the first side surface 152_S1 and an upper surface of the barrier layer 136. The first side surface 152_S1 may extend in the third direction (Z direction). The third side surface 152_S3 may be convex toward the upper surface of the barrier layer 136, but example implementations are not limited thereto. The second side surface 152_S2 may be an inclined surface sloped from the upper surface of the barrier layer 136.

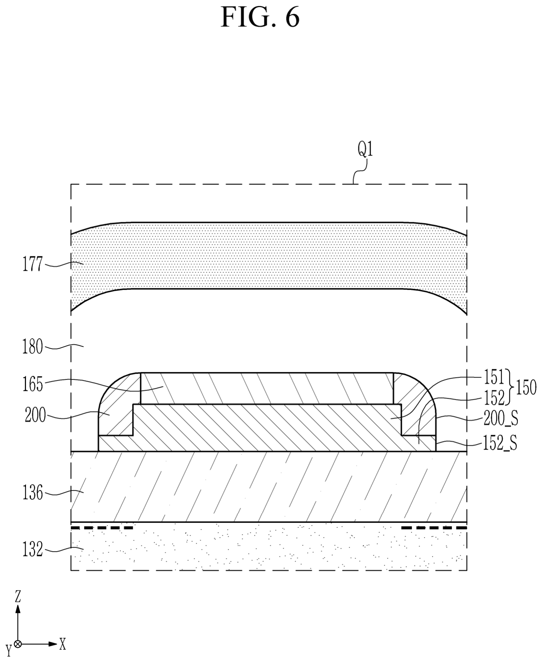

Referring to FIG. 6, the semiconductor device may not include a hard mask layer 167. For example, the protective layer 180 may be positioned directly on the gate electrode 165. The upper surface of the gate electrode 165 and the upper surface of the gate spacer 200 may be in contact with the protective layer 180. In some implementations, an upper surface of the gate spacer 200 may be positioned at substantially the same level as an upper surface of the gate electrode 165. The distance between the upper surface of the gate spacer 200 and the upper surface of the channel layer 132 may be substantially equal to the distance between the upper surface of the gate electrode 165 and the upper surface of the channel layer 132. This may be due to the characteristics of the process of forming the gate spacer 200 after removal of the hard mask layer 167.

Referring to FIG. 7, the (e.g., each) second pattern portion 152 of the semiconductor device may be spaced apart from the first pattern portion 151. For example, the second pattern portion 152 may be spaced apart from the first pattern portion 151 in the first direction (X direction). The thickness of the second pattern portion 152 in the third direction (Z direction) may be less than the thickness of the first pattern portion 151 in the third direction (Z direction). In addition, the width of the second pattern portion 152 in the first direction (X direction) may be less than the width of the first pattern portion 151 in the first direction (X direction). The second pattern portion 152 may be floating.

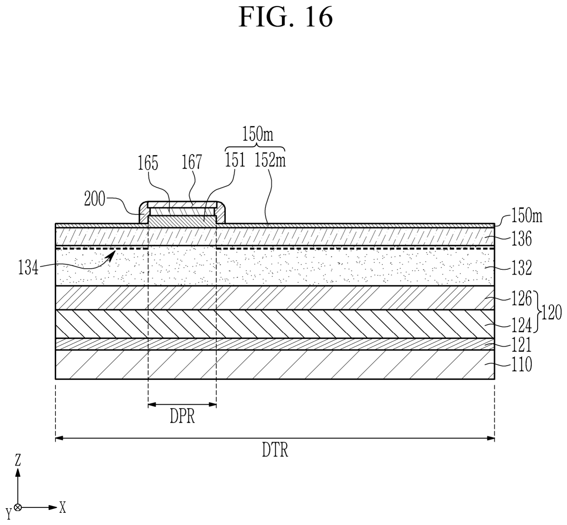

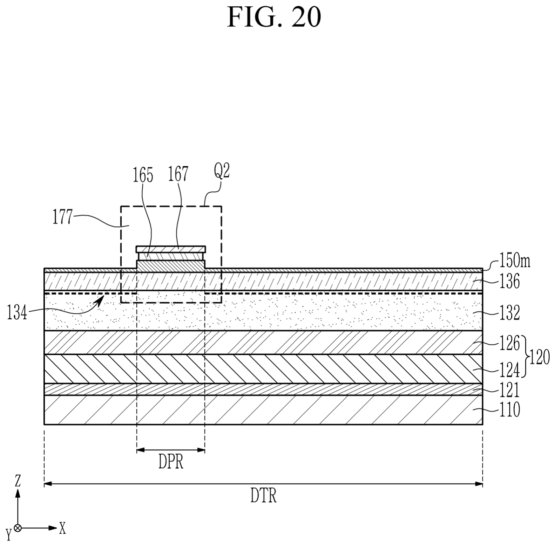

A protective layer 180 may be positioned between the second pattern portion 152 and the first pattern portion 151. Opposite side surfaces of the second pattern portion 152 may be in contact with the protective layer 180. Opposite side surfaces of the second pattern portion 152 may be aligned with the gate spacer 200 in the third direction (Z direction). As the gate spacer 200 is formed spaced apart from the gate electrode 165 in the first direction (X direction), during the process of patterning the gate semiconductor material layer 150m (see FIG. 16) using the gate spacer 200 and the gate electrode 165 as a mask, a portion of the gate semiconductor material layer 150m (see FIG. 16) positioned between the gate spacer 200 and the gate electrode 165 is removed. Description thereof will be given below with reference to FIGS. 20, 21, 22, 23, 24A, and 24B.

In some implementations, the gate spacer 200 may be spaced apart from the first pattern portion 151 in the first direction (X direction). A protective layer 180 may be positioned between the gate spacer 200 and the first pattern portion 151. In addition, the gate spacer 200 may be spaced apart from the gate electrode 165 in the first direction (X direction). The upper surface of the gate spacer 200 may be positioned at substantially the same level as the upper surface of the first pattern portion 151. The distance between the upper surface of the gate spacer 200 and the upper surface of the channel layer 132 may be substantially the same as the distance between the upper surface of the first pattern portion 151 and the upper surface of the channel layer 132. In the implementation of FIG. 7, the hard mask layer 167 (see FIG. 1) of the implementations of FIGS. 1 to 3 may be omitted, but example implementations are not limited thereto.

Referring to FIG. 8, the gate semiconductor layer 150 of the semiconductor device may further include a third pattern portion 153 positioned between the first pattern portion 151 and the second pattern portion 152.

The third pattern portion 153 may be positioned on the barrier layer 136. The third pattern portion 153 may be positioned between the barrier layer 136 and the protective layer 180. The third pattern portion 153 may be non-overlapping with the gate electrode 165 and the gate spacer 200 in a third direction (Z direction). The third pattern portion 153 may be non-overlapping with the gate spacer 200 in the first direction (X direction), but example implementations are not limited thereto. An upper surface of the third pattern portion 153 may contact the protective layer 180. The thickness of the third pattern portion 153 in the third direction (Z direction) may be less than or equal to the thickness of the second pattern portion 152 in the third direction (Z direction). The third pattern portion 153 may be a pattern in which a portion of the gate semiconductor material layer 150m in FIG. 14 positioned between the gate spacer 200 and the gate electrode 165 is patterned and formed. In the implementation of FIG. 8, the hard mask layer 167 (see FIG. 1) of the implementation of FIGS. 1 to 3 may be omitted, but example implementations are not limited thereto.

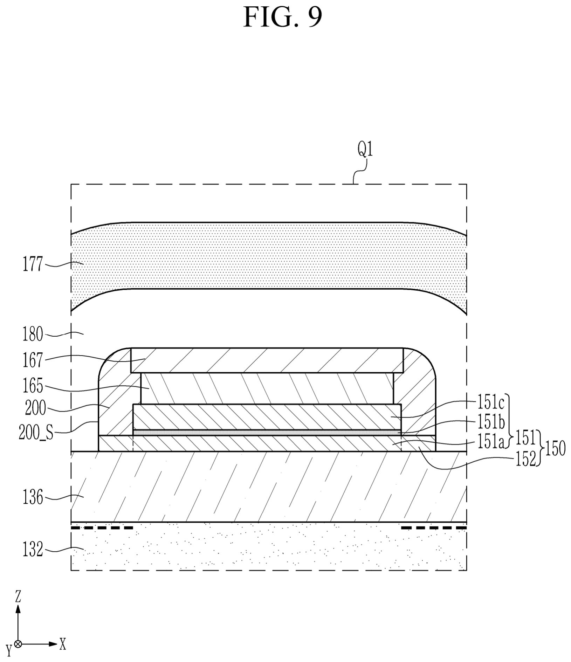

Referring to FIG. 9, the first pattern portion 151 of the semiconductor device according to several implementations may include a first pattern layer 151a, a second pattern layer 151b, and a third pattern layer 151c that are sequentially stacked on the barrier layer 136.

The first pattern layer 151a may be positioned on the upper surface of the barrier layer 136. The upper surface of the first pattern layer 151a may be positioned at substantially the same level as the upper surface of the second pattern portion 152. The distance between the upper surface of the first pattern layer 151a and the upper surface of the channel layer 132 may be substantially the same as the distance between the upper surface of the second pattern portion 152 and the upper surface of the channel layer 132. The thickness of the first pattern layer 151a in the third direction (Z direction) may be substantially the same as the thickness of the second pattern portion 152 in the third direction (Z direction). This may be due to the process characteristics in which, during the patterning of the gate semiconductor material layer 150m (see FIG. 14), the second pattern layer 151b part and the third pattern layer 151c part positioned on the second pattern portion 152 are etched so that the second pattern portion 152 and the first pattern layer 151a are exposed. The thickness of the first pattern layer 151a in the third direction (Z direction) may be about 3 nm to about 30 nm, but example implementations are not limited thereto. The first pattern layer 151a may include GaN.

The third pattern layer 151c may be positioned on the first pattern layer 151a. A side surface of the third pattern layer 151c may be aligned with a side surface of the first pattern layer 151a in a third direction (Z direction). The side surface of the third pattern layer 151c may contact the gate spacer 200. The third pattern layer 151c may include the same material as the first pattern layer 151a. For example, the third pattern layer 151c may include GaN.

The second pattern layer 151b may be positioned on the first pattern layer 151a. The second pattern layer 151b may be positioned between the first pattern layer 151a and the third pattern layer 151c. A side surface of the second pattern layer 151b may be aligned with a side surface of the first pattern layer 151a in the third direction (Z direction). The side surface of the second pattern layer 151b may be in contact with the gate spacer 200. The thickness in the third direction (Z direction) of the second pattern layer 151b may be less than the thickness in the third direction (Z direction) of the first pattern layer 151a and the thickness in the third direction (Z direction) of the third pattern layer 151c. The thickness of the second pattern layer 151b in the third direction (Z direction) may be about 0.5 nm to about 5 nm, but example implementations are not limited thereto.

The second pattern layer 151b may include a material different from the first pattern layer 151a and the third pattern layer 151c. As the second pattern layer 151b includes a material different from the first pattern layer 151a and the third pattern layer 151c, the second pattern layer 151b may function as an etch stop layer for forming the second pattern portion 152. For example, the second pattern layer 151b may include AlₓIn_{y}Ga_{1-x-y}N (0.05≤x≤0.15, 0.05≤y≤0.15, x+y≤1). By way of example, the content (at%) of Al or the content (at%) of In in the second pattern layer 151b may be about 5 at% to about 15 at%. When the composition ratio of Al and/or the composition ratio of In is less than about 0.05, the etch selectivity of the first pattern layer 151a to the second pattern layer 151b with respect to the etching material for etching the second pattern layer 151b may decrease. In another example, when the composition ratio of Al and/or the composition ratio of In is less than 0.05, the intensity of the signal (for example, EPD Signal) for detecting an etching endpoint of the second pattern layer 151b may decrease. When the composition ratio of Al and/or the composition ratio of In is greater than 0.15, a depletion region DPR may not be smoothly formed within the channel layer 132.

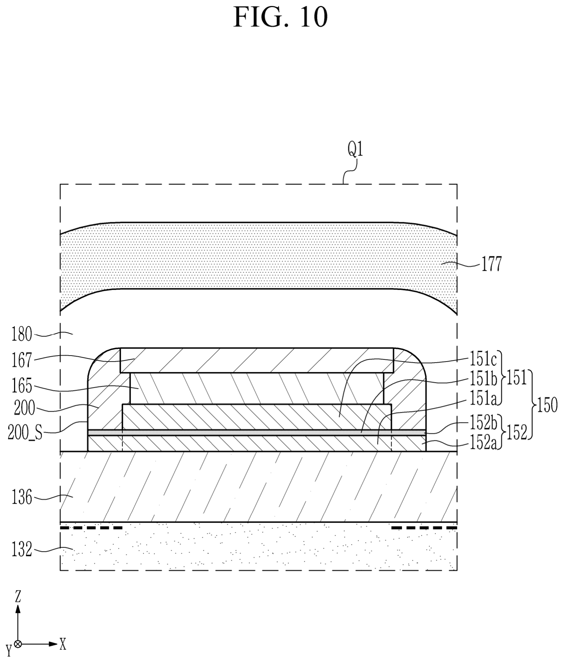

Referring further to FIG. 10, the second pattern portion 152 of the semiconductor device may include a fourth pattern layer 152a positioned on the barrier layer 136 and a fifth pattern layer 152b positioned on the fourth pattern layer 152a.

The fourth pattern layer 152a may be positioned on the barrier layer 136. The fourth pattern layer 152a may be formed integrally with the first pattern layer 151a. The thickness of the fourth pattern layer 152a in the third direction (Z direction) may be substantially equal to the thickness of the first pattern layer 151a in the third direction (Z direction). The fourth pattern layer 152a may include the same material as the first pattern layer 151a. For example, the fourth pattern layer 152a may include GaN.

The fifth pattern layer 152b may be positioned between the fourth pattern layer 152a and the gate spacer 200. The fifth pattern layer 152b may be integrally formed with the second pattern layer 151b. The thickness of the fifth pattern layer 152b in the third direction (Z direction) may be substantially the same as the thickness of the second pattern layer 151b in the third direction (Z direction). The fifth pattern layer 152b may include the same material as the second pattern layer 151b. For example, the fifth pattern layer 152b may include AlₓIn_{y}Ga_{1-x-y}N (0.05≤x≤0.15, 0.05≤y≤0.15, x+y≤1). For example, the content (at%) of Al or the content (at%) of In in the fifth pattern layer 152b may be about 5 at% to about 15 at%.

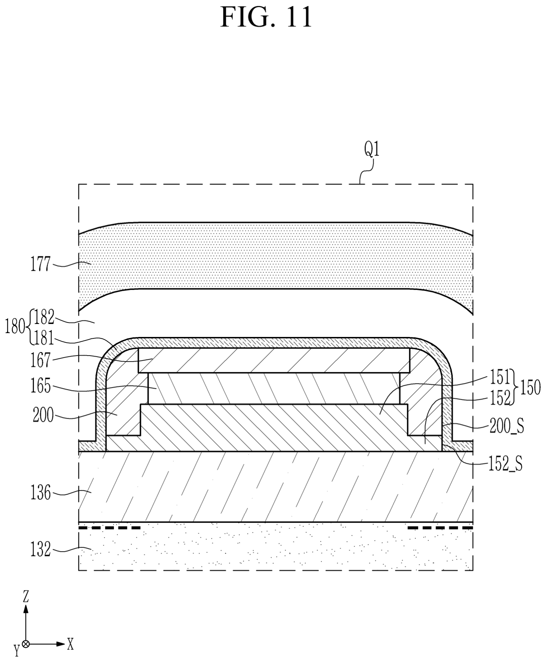

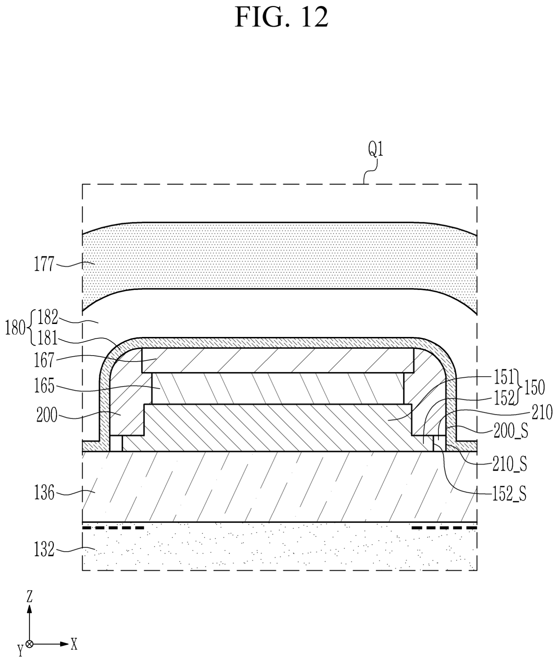

Referring to FIG. 11 and FIG. 12, in some implementations, the protective layer 180 of another semiconductor device may include a first protective layer 181 positioned on the barrier layer 136 and a second protective layer 182 positioned on the first protective layer 181.

The first protective layer 181 may be positioned on the upper surface of the barrier layer 136, on the upper surface of the gate spacer 200, and on the upper surface of the hard mask layer 167. The first protective layer 181 may be positioned on the side surface 152_S of the second pattern portion 152. The first protective layer 181 may be conformally positioned on the upper surface of the barrier layer 136, the side surface 152_S of the second pattern portion 152, the upper surface of the gate spacer 200, and the upper surface of the hard mask layer 167. The first protective layer 181 may include one or more of various insulating materials. For example, the first protective layer 180 may include SiN, SiON, AIN, or a combination thereof, but example implementations are not limited thereto. The first protective layer 181 may perform a function of injecting electrons into the channel layer 132 and/or the barrier layer 136.

The second protective layer 182 may be positioned on the first protective layer 181. The second protective layer 182 may be positioned between the first protective layer 181 and the field dispersion layer 177. The thickness of the second protective layer 182 in the third direction (Z direction) may be greater than the thickness of the first protective layer 181 in the third direction (Z direction). The second protective layer 182 may include a material different from that of the first protective layer 181. For example, the second protective layer 182 may include SiO₂ and Al₂O₃, but example implementations are not limited thereto. The barrier layer 136, gate semiconductor layer 150, and gate electrode 165 may be protected by the second protective layer 182.

As shown in FIG. 12, a semiconductor device may further include a spacer pattern 210 positioned between the second pattern portion 152 and the first protective layer 181.

The spacer pattern 210 may be positioned at at least one side of the second pattern portion 152. The spacer pattern 210 may be positioned on the side surface 152_S of the second pattern portion 152. The spacer pattern 210 may be positioned between the barrier layer 136 and the gate spacer 200. The side surface 210_S of the spacer pattern 210 may be aligned with the side surface 200_S of the gate spacer 200 in the third direction (Z direction). The thickness of the spacer pattern 210 in the third direction (Z direction) may be substantially the same as the thickness of the second pattern portion 152 in the third direction (Z direction). The spacer pattern 210 may include one or more of various insulating materials. For example, the spacer pattern 210 may include SiO₂. In another example, the spacer pattern 210 may include an oxide such as Al₂O₃ or a carbonated oxide such as SiOC. As another example, the spacer pattern 210 may be configured as an air gap. The spacer pattern 210 may be a pattern formed in an over-etched space where the second pattern portion 152 is formed, in the process of forming the second pattern portion 152 using the gate spacer 200 as a mask.

Accordingly, by the spacer pattern 210, the gate semiconductor layer 150 may be spaced apart from the first protective layer 181. The spacer pattern 210 may prevent electrons from being introduced into the gate semiconductor layer 150 from the first protective layer 181. Therefore, it may be possible to prevent deterioration of characteristics such as the breakdown voltage of the semiconductor device by the first protective layer 181.

Hereinafter, a method of manufacturing a semiconductor device will be described with reference to FIGS. 13, 14, 15, 16, 17, 18A, 18B, and 19.

FIGS. 13, 14, 15, 16, 17, 18A, 18B, and 19 are process cross-sectional views of intermediate steps illustrating an example of a method of manufacturing a semiconductor device.

As shown in FIG. 13, a seed layer 121, a buffer layer 120, a channel layer 132, a barrier layer 136, a gate semiconductor material layer 150m, a gate electrode material layer 165m, and a hard mask material layer 167m may be sequentially formed on the substrate 110.

The substrate 110 may include a semiconductor material. For example, substrate 110 may include sapphire, Si, SiC, AIN, GaN, or a combination thereof. The substrate 110 may be a SOI (Silicon on Insulator) substrate. However, the material of the substrate 110 is not limited thereto, and any substrate generally used may be applied.

The seed layer 121 and the superlattice layer 124 may be sequentially formed using an epitaxial growth method. The seed layer 121 and the superlattice layer 124 may be formed of a semiconductor material of the same base. However, the material composition ratio of each layer may be different in consideration of the role of each layer, the performance required for the semiconductor device, and the like. The seed layer 121 and the superlattice layer 124 may include one or more materials selected from group III-V materials, for example, nitrides including Al, Ga, In, B, or combinations thereof. The seed layer 121 and the superlattice layer 124 may be AlₓIn_{y}Ga_{1-x-y}N (0≤x≤1, 0≤y≤1,x+y≤1). For example, the seed layer 121 and the superlattice layer 124 may include AIN, GaN, InN, InGaN, AlGaN, AlInN, AlInGaN, or a combination thereof.

In some implementations, the superlattice layer 124 may be formed as a multilayer in which layers including different materials are alternately stacked. For example, the superlattice layer 124 may have a structure in which layers made of AlGaN and layers made of AIN are repeatedly stacked. That is, AlGaN/AlN/AlGaN/AlN/AlGaN/AlN may be sequentially stacked to form a superlattice layer 124.

The high-resistance layer 126 may be formed of a material having low conductivity so that the substrate 110 and the channel layer 132 may be electrically insulated from each other. The high resistance layer may include one or more materials selected from group III-V materials, for example, nitrides including Al, Ga, In, B, or combinations thereof. The high-resistance layer 126 may be AlₓIn_{y}Ga_{1-x-y}N (0≤x≤1, 0≤y≤1, x+y≤1). For example, the high-resistance layer 126 may include AIN, GaN, InN, InGaN, AlGaN, AlInN, AlinGaN, or combinations thereof. The high-resistance layer 126 may be formed as a single layer or a multilayer.

In some implementations, the channel layer 132 and the barrier layer 136 may be sequentially formed using an epitaxial growth method. For example, the channel layer 132 may be formed on the high-resistance layer 126, and the barrier layer 136 may be formed on the channel layer 132.

The channel layer 132 and the barrier layer 136 may be formed of the same base semiconductor material. However, the material composition ratio of each layer may be different in consideration of the role of each layer, the performance required for the semiconductor device, and the like. The channel layer 132 and barrier layer 136 may include one or more materials selected from group III-V materials, for example, nitrides including Al, Ga, In, B, or combinations thereof. The channel layer 132 and the barrier layer 136 may be AlₓIn_{y}Ga_{1-x-y}N (0≤x≤1, 0≤y≤1,x+y≤1). For example, the channel layer 132 and the barrier layer 136 may include AIN, GaN, InN, InGaN, AlGaN, AlInN, AlinGaN, or combinations thereof. The barrier layer 136 may include a material having a different energy band gap from an energy band gap of the channel layer 132. The barrier layer 136 may have a higher energy band gap than the channel layer 132.

As one example, substrate 110 includes Si, seed layer 121 includes AIN, and superlattice layer 124 may include AlGaN and AIN. The high-resistance layer 126 includes GaN, the channel layer 132 includes GaN, and the barrier layer 136 may include AlGaN. The channel layer 132 and the barrier layer 136 may be doped with impurities, or may not be doped.

A gate semiconductor material layer 150m may be formed on the barrier layer 136. The gate semiconductor material layer 150m may include at least one material selected from group III-V materials, for example, nitrides including Al, Ga, In, B, or combinations thereof. The gate semiconductor material layer 150m may be AlₓIn_{y}Ga_{1-x-y}N (0≤x≤1, 0≤y≤1, x+y≤1). For example, the gate semiconductor material layer 150m may include AIN, GaN, InN, InGaN, AlGaN, AlInN, AllnGaN, or a combination thereof.

The gate electrode material layer 165m may be formed using a deposition process. For example, the gate electrode material layer 165m may be formed by using at least one of physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) techniques; however, example implementations are not limited thereto.

The gate electrode material layer 165m may include a conductive material. For example, the gate electrode material layer 165m may include a metal, metal alloy, conductive metal nitride, metal silicide, doped semiconductor material, conductive metal oxide, or conductive metal oxynitride and the like. The gate electrode material layer 165m may be formed as a single layer or a multilayer.

A hard mask material layer 167m may be formed on the gate electrode material layer 165m. The hard mask material layer 167m may include SiO₂, SiN, SiON, or a combination thereof. However, example implementations are not limited thereto, and the hard mask material layer 167m may be removed during the subsequent etching of the gate electrode material layer 165m and/or the gate semiconductor material layer 150m, depending on the etching conditions or the cleaning conditions after etching.

As shown in FIG. 14, the gate electrode material layer 165m may be patterned to form the gate electrode 165, and at least a portion of the gate semiconductor material layer 150m may be etched.

First, by patterning the hard mask material layer 167m using a photo and etching process, a hard mask layer 167 may be formed. For example, a photoresist layer may be formed on the hard mask material layer 167m. A photoresist layer may be patterned using a photo process to form a photoresist pattern. By etching the hard mask material layer 167m and the gate electrode material layer 165m using the photoresist pattern as a mask, the hard mask layer 167 and the gate electrode 165 may be formed. Accordingly, a portion of the remaining gate electrode material layer 165m may become the gate electrode 165.

Subsequently, the hard mask layer 167 may be used as a mask to etch at least a portion of the gate semiconductor material layer 150m. Accordingly, the thickness of the exposed gate semiconductor material layer 150m may be reduced. For example, a portion of the gate semiconductor material layer 150m overlapping the hard mask layer 167 and/or the gate electrode 165 in the third direction (Z direction) may not be etched, and the exposed portion of the gate semiconductor material layer 150m may be etched so that its thickness may be reduced. Here, a portion of the gate semiconductor material layer 150m overlapping with the hard mask layer 167 and/or the gate electrode 165 in the third direction (Z direction) is referred to as the first pattern portion 151. A portion of the gate semiconductor material layer 150m having a reduced thickness is referred to as the second preliminary pattern portion 152m.

The second preliminary pattern portion 152m may be positioned at opposite sides of the first pattern portion 151 in the first direction (X direction). The second preliminary pattern portion 152m may completely cover the barrier layer 136. An upper surface of the barrier layer 136 may be covered by the second preliminary pattern portion 152m. Accordingly, the upper surface of the barrier layer 136 may not be exposed.

As at least a portion of the gate semiconductor material layer 150m is etched, the thickness of the second preliminary pattern portion 152m in the third direction (Z direction) may be less than the thickness of the first pattern portion 151 in the third direction (Z direction). For example, the thickness of the second preliminary pattern portion 152m in the third direction (Z direction) may be about 1/50 to about 1/2 of the thickness of the first pattern portion 151 in the third direction (Z direction). Preferably, the thickness of the second preliminary pattern portion 152m in the third direction (Z direction) may be about 1/10 to about 1/5 of the thickness of the first pattern portion 151 in the third direction (Z direction). When the thickness of the second preliminary pattern portion 152m in the third direction (Z direction) is less than 1/50 (preferably 1/10) of the thickness of the first pattern portion 151 in the third direction (Z direction), the second preliminary pattern portion 152m may have a reduced function of dispersing an electric field concentrated around the gate electrode 165. When the thickness of the second preliminary pattern portion 152m in the third direction (Z direction) is greater than 1/2 (preferably 1/5) of the thickness of the first pattern portion 151 in the third direction (Z direction), the concentration of the two-dimensional electron gas 134 in the portion of the channel layer 132 overlapping the second preliminary pattern portion 152m in the third direction (Z direction) by the second preliminary pattern portion 152m may decrease. Accordingly, the channel resistance of the semiconductor device may increase, and the characteristics of the semiconductor device may deteriorate. The thickness of the second preliminary pattern portion 152m in the third direction (Z direction) within this range may be about 3 nm to about 30 nm, but example implementations are not limited thereto.

As shown in FIG. 15 and FIG. 16, a gate spacer 200 may be formed on the gate semiconductor material layer 150m.

First, referring to FIG. 15, a gate spacer material layer 200m may be formed on the gate semiconductor material layer 150m. The gate spacer material layer 200m may be formed using a deposition process. The gate spacer material layer 200m may be conformally formed on the upper surface of the gate semiconductor material layer 150m, the side surface of the first pattern portion 151, the side surface of the gate electrode 165, the side surface of the hard mask layer 167, and on the upper surface of the hard mask layer 167. The gate spacer material layer 200m may include SiO₂. In another example, the gate spacer material layer 200m may include an oxide such as Al₂O₃ or a carbonated oxide such as SiOC.

Subsequently, referring to FIG. 16, the gate spacer material layer 200m may be etched to form a gate spacer 200 positioned on opposite sides of the first pattern portion 151.

The process of forming the gate spacer 200 by etching the gate spacer material layer 200m may be carried out through an etch-back process using a dry etching method and/or a wet etching method. As the gate spacer material layer 200m is positioned on the second preliminary pattern portion 152m, the barrier layer 136 may not be exposed in the process of etching the gate spacer material layer 200m by performing an etch back process. Accordingly, it may be possible to prevent damage to the barrier layer 136 and/or the channel layer 132 by the etching material for etching the gate spacer material layer 200m.

The gate spacer 200 may be positioned on the upper surface of the second preliminary pattern portion 152m. The gate spacer 200 may be positioned on the side surface of the first pattern portion 151. The gate spacer 200 may cover the side surface of the first pattern portion 151. The gate spacer 200 may be positioned on the side surface of the gate electrode 165. In some implementations, the gate spacer 200 may completely cover the side surface of the first pattern portion 151 and the side surface of the gate electrode 165, and may cover at least a portion of the side surface of the hard mask layer 167.

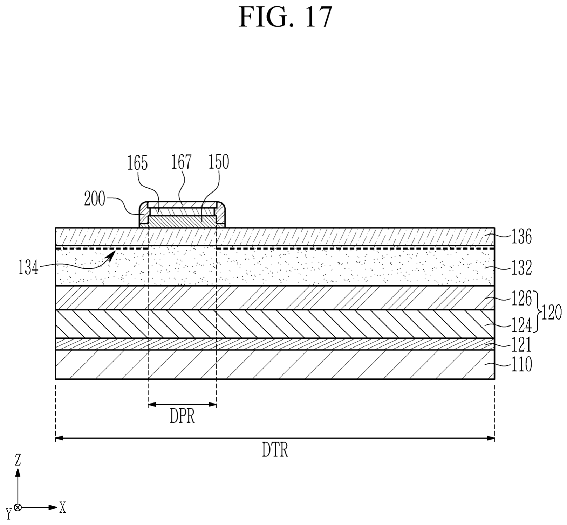

As shown in FIG. 17, the gate spacer 200 may be used as a mask to pattern the gate semiconductor material layer 150m to form the gate semiconductor layer 150.

The process of patterning the gate semiconductor material layer 150m may be performed using an etching material having an etch selectivity with respect to the barrier layer 136. Accordingly, a gate semiconductor layer 150 including a portion overlapping with the gate spacer 200 in the third direction (Z direction) may be formed. As the patterning is performed using the gate spacer 200 as a mask, one end of the gate semiconductor layer 150 may be aligned with the side surface of the gate spacer 200 in the third direction (Z direction).

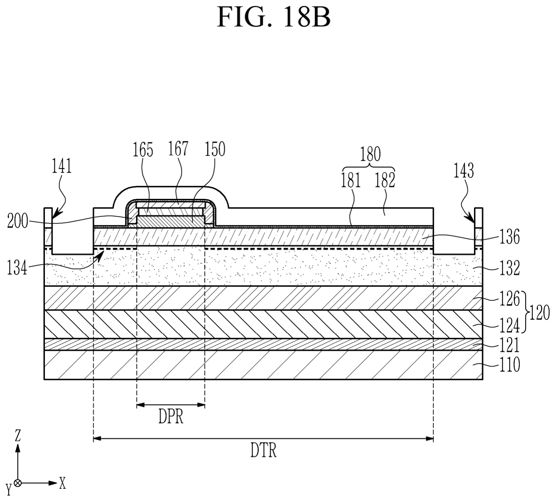

As illustrated in FIGS. 18A and 18B, a protective layer 180 may be formed on the upper surface of the barrier layer 136, and the protective layer 180 may be patterned to form a first trench 141 and a second trench 143.

A protective layer 180 may be formed on the upper surface of the barrier layer 136, the upper surface of the gate spacer 200, and the upper surface of the hard mask layer 167. The protective layer 180 may be formed by using a deposition process. For example, the protective layer 180 may be formed using at least one of a physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) technique, but example implementations are not limited thereto.

The protective layer 180 may be positioned on the barrier layer 136 and the hard mask layer 167. The protective layer 180 may be positioned on the gate spacer 200. The protective layer 180 may cover the hard mask layer 167 and the gate spacer 200. The protective layer 180 may be positioned conformally on the upper surface of the barrier layer 136, the upper surface of the hard mask layer 167, and on the gate spacer 200. Accordingly, the barrier layer 136, the hard mask layer 167, and the gate electrode 165 may be protected by the protective layer 180. A lower surface of the protective layer 180 may contact the barrier layer 136, the gate spacer 200, and the gate electrode 165. The protective layer 180 may contact the upper surface of the gate electrode 165.

The protective layer 180 may be patterned to form the first trench 141 and the second trench 143.

First, by patterning the protective layer 180 using photo and etching processes, the first trench 141 and the second trench 143 may be formed. In this case, not only the protective layer 180, but also the barrier layer 136 and the channel layer 132 may be patterned together.

For example, a photoresist pattern may be formed on the protective layer 180, and the protective layer 180, the barrier layer 136, and the channel layer 132 may be sequentially etched using the photoresist pattern as a mask. In this case, the protective layer 180 and the barrier layer 136 may be penetrated by the first trench 141 and the second trench 143, and the upper surface of the channel layer 132 may be recessed. The channel layer 132 may not be completely penetrated by the first trench 141 or the second trench 143. That is, the depth by which the upper surface of the channel layer 132 is recessed may be less than the entire thickness of the channel layer 132. In this case, the depth to which the upper surface of the channel layer 132 is recessed may be much less than the entire thickness of the channel layer 132. In addition, the depth by which the upper surface of the channel layer 132 is recessed may be greater than the thickness of the barrier layer 136. However, example implementations are not limited thereto, and the depth to which the upper surface of the channel layer 132 is recessed may be variously changed.

The side surface of the protective layer 180 and the side surface of the barrier layer 136 may be exposed to the outside by the first trench 141 and the second trench 143, and the upper surface and side surface of the channel layer 132 may be exposed. The channel layer 132 may form the bottom surface and sidewalls of the first trench 141 and the second trench 143, and the barrier layer 136 may form the sidewalls of the first trench 141 and the second trench 143.

The first trench 141 and the second trench 143 may be spaced apart from each other. The first trench 141 and the second trench 143 may be positioned on opposite sides of the gate electrode 165. The first trench 141 may be positioned at one side of the gate electrode 165 so as to be spaced apart from the gate electrode 165. The second trench 143 may be positioned on the other side of the gate electrode 165 so as to be spaced apart from the gate electrode 165. The distance by which the first trench 141 is spaced apart from the gate electrode 165 may be less than the distance by which the second trench 143 is spaced apart from the gate electrode 165. The width, depth, and other shapes of the first trench 141 and the second trench 143 are illustrated as being similar, but example implementations are not limited thereto. The shapes of the first trench 141 and the second trench 143 may be variously modified.

The protective layer 180 may be a single layer or a multilayer. For example, as shown in FIG. 18A, the protective layer 180 may be formed as a single layer. As another example, as shown in FIG. 18B, the protective layer 180 may include a first protective layer 181 positioned on the barrier layer 136 and a second protective layer 182 positioned on the first protective layer 181.

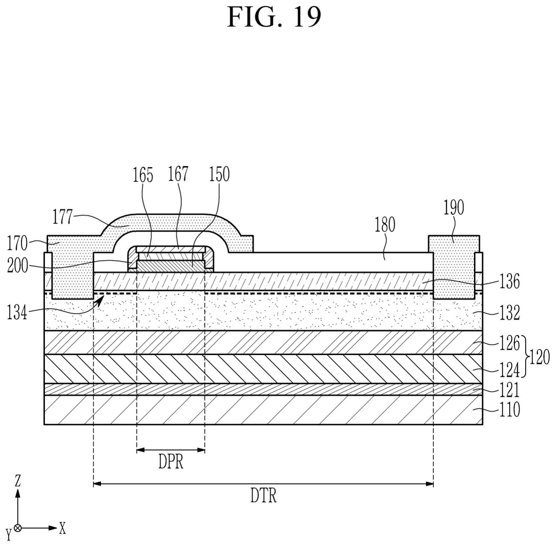

As illustrated in FIG. 19, a source electrode 170 may be formed in the first trench 141, and a drain electrode 190 may be formed in the second trench 143 to form a semiconductor device.

A conductive material may be deposited in the first trench 141 and the second trench 143, and then patterned to form the source electrode 170 and the drain electrode 190.

The source electrode 170 and the drain electrode 190 may include a conductive material. For example, the source electrode 170 and the drain electrode 190 may include a metal, a metal alloy, a conductive metal nitride, a metal silicide, a doped semiconductor material, a conductive metal oxide, or a conductive metal oxynitride. The source electrode 170 and the drain electrode 190 may be formed as a single layer or a multilayer. For example, a plurality of conductive layers including different materials may be laminated and then patterned to form the source electrode 170 and the drain electrode 190.

The source electrode 170 may be formed to fill the inside of the first trench 141. In addition, the source electrode 170 may be formed so as to cover at least a portion of an upper surface of the protective layer 180. Accordingly, at least a portion of the source electrode 170 may overlap the channel layer 132 and the barrier layer 136 in the third direction (Z direction). In the first trench 141, the source electrode 170 may contact the channel layer 132 and the barrier layer 136. The source electrode 170 may contact a side surface of the channel layer 132 and a side surface of the barrier layer 136. The source electrode 170 may cover the side surface of the channel layer 132 and the side surface of the barrier layer 136. The source electrode 170 may be electrically connected to the channel layer 132 through the first trench 141. An upper surface of the source electrode 170 may protrude beyond an upper surface of the protective layer 180.

The drain electrode 190 may be formed to fill the inside of the second trench 143. In addition, the drain electrode 190 may be formed to cover at least a portion of an upper surface of the protective layer 180. Accordingly, at least a portion of the drain electrode 190 may overlap with the channel layer 132 and the barrier layer 136 in the third direction (Z direction). In the second trench 143, the drain electrode 190 may contact the channel layer 132 and the barrier layer 136. The drain electrode 190 may contact a side surface of the channel layer 132 and a side surface of the barrier layer 136. The drain electrode 190 may cover the side surface of the channel layer 132 and the side surface of the barrier layer 136. The drain electrode 190 may be electrically connected to the channel layer 132 through the second trench 143. An upper surface of the drain electrode 190 may protrude on an upper surface of the protective layer 180. The source electrode 170 and the drain electrode 190 may be in ohmic contact with the channel layer 132.

In the step of forming the source electrode 170 and the drain electrode 190, the field dispersion layer 177 may be formed together. The field dispersion layer 177 may be positioned between the source electrode 170 and the drain electrode 190. The field dispersion layer 177 may overlap the gate electrode 165, but example implementations are not limited thereto. In another example, the field dispersion layer 177 may be spaced apart from the source electrode 170 in the first direction (X direction). The field dispersion layer 177 may be electrically connected to the source electrode 170. The field dispersion layer 177 may be formed integrally with the source electrode 170. The field dispersion layer 177 may include the same material as the source electrode 170, and may be positioned in the same layer as the source electrode 170.

Hereinafter, a method for manufacturing a semiconductor device will be described with reference to FIGS. 20, 21, 22, 23, 24A, and 24B.

FIGS. 20, 21, 22, 23, 24A, and 24B are process cross-sectional views of intermediate steps illustrating a method of manufacturing a semiconductor device. FIGS. 20, 21, 22, 23, 24A, and 24B illustrate a method for manufacturing a semiconductor device shown in FIG. 7 and FIG. 8.

FIGS. 20, 21, 22, 23, 24A, and 24B illustrate various modified examples of a semiconductor device shown in FIGS. 13 to 19. FIGS. 20 to 23, FIG. 24A, and FIG. 24B illustrate implementations in which the portions identical to those of the implementations shown in FIGS. 13 to 19 are significant. Accordingly, a description thereof will be omitted, and only the differences will be mainly described. In addition, the same reference numerals are used for the same components as in the previous implementations.

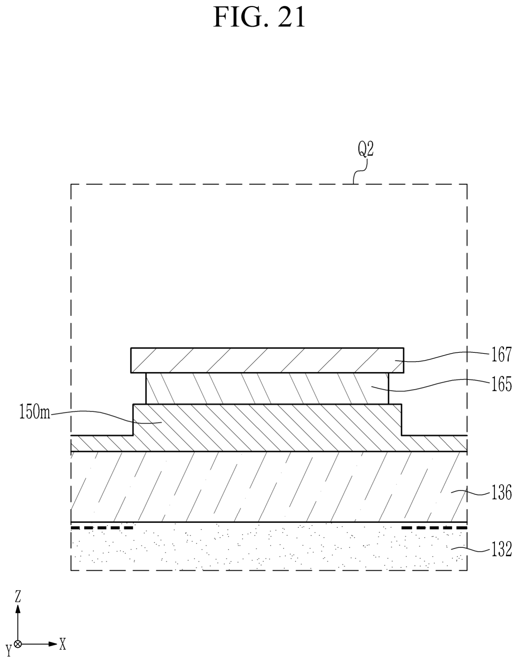

Referring to FIG. 20 and FIG. 21, a seed layer 121, a buffer layer 120, a channel layer 132, a barrier layer 136, and a gate semiconductor material layer 150m may be sequentially formed on the substrate 110. Next, the gate electrode 165 and hard mask layer 167 may be formed on the gate semiconductor material layer 150m. Next, at least a portion of the gate semiconductor material layer 150m may be etched.

The process of forming the gate electrode 165 may be carried out using the hard mask layer 167 as a mask. In this case, the gate electrode 165 may be sufficiently etched. The gate electrode 165 may have a recessed inner side relative to the hard mask layer 167. Here, the inner side refers to the direction toward the center of the gate electrode 165. For instance, the gate electrode 165 may have a side wall that is recessed inwardly (e.g. in the first direction, towards the center of the gate electrode 165) relative to the hard mask layer 167. The width of the gate electrode 165 in the first direction (X direction) may be less than the width of the hard mask layer 167 in the first direction (X direction). A side surface of the gate electrode 165 may be misaligned with a side surface of the gate semiconductor material layer 150m in the third direction (Z direction). Accordingly, a portion of the gate semiconductor material layer 150m may be exposed together.

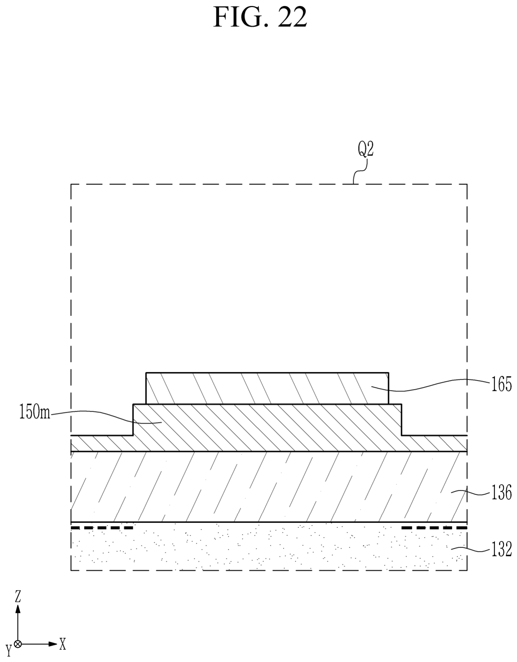

Referring to FIG. 22, the hard mask layer 167 may be removed. Accordingly, the gate electrode 165 may be exposed. The hard mask layer 167 may be removed during etching or after etching and cleaning of the gate semiconductor material layer 150m (see FIG. 13), depending on the etching or cleaning conditions.

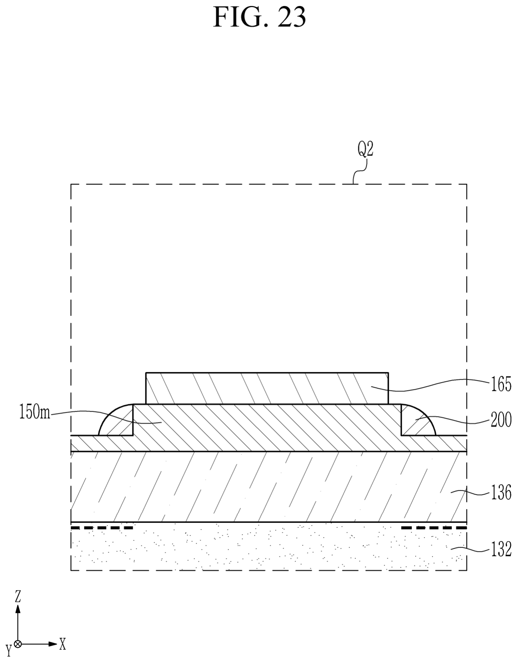

Referring to FIG. 23, a gate spacer 200 may be formed on the gate semiconductor material layer 150m.

First, a gate spacer material layer may be formed on the gate semiconductor material layer 150m. The gate spacer material layer may be formed using a deposition process. Subsequently, the gate spacer material layer may be etched to form the gate spacer 200 positioned on opposite sides of the first pattern portion 151. The process of etching the gate spacer material layer to form the gate spacer 200 may be carried out through an etch back process using a dry etching method and/or a wet etching method. The side surface of the gate electrode 165 and the side surface of the gate semiconductor material layer 150m are misaligned in the third direction (Z direction). Unlike the implementations of FIGS. 13 to 19, as the hard mask layer 167 is removed, the gate spacer 200 may be formed at a relatively low height.

The gate spacer 200 may be non-overlapping with the gate electrode 165 in the first direction (X direction). The gate spacer 200 may be spaced apart from the gate electrode 165 in the first direction (X direction). The gate spacer 200 may not be in contact with the side surface of the gate electrode 165. The upper surface of the gate spacer 200 may be positioned at substantially the same level as the upper surface of the gate semiconductor material layer 150m. The distance between the upper surface of the gate spacer 200 and the upper surface of the channel layer 132 may be substantially the same as the distance between the upper surface of the gate semiconductor material layer 150m and the upper surface of the channel layer 132.

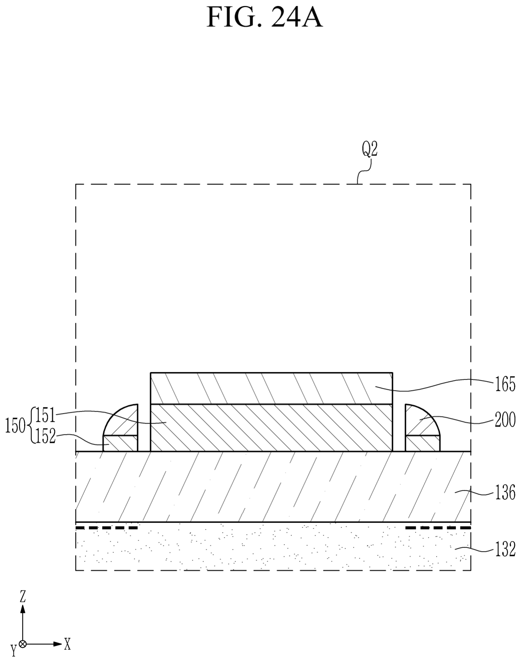

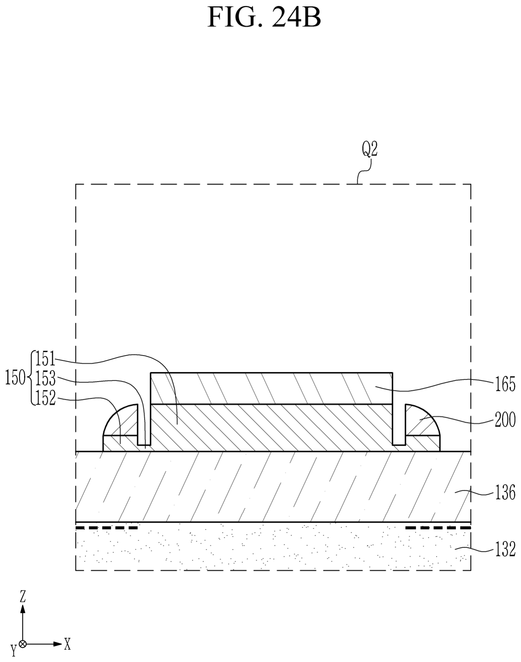

Referring to FIG. 24A and FIG. 24B, the gate semiconductor material layer 150m may be patterned using the gate spacer 200 as a mask to form the gate semiconductor layer 150.

The process of patterning the gate semiconductor material layer 150m may be performed using an etching material having an etch selectivity with respect to the barrier layer 136. Accordingly, a gate semiconductor layer 150 including a portion overlapping the gate spacer 200 in the third direction (Z direction) may be formed. By patterning using the gate spacer 200 as a mask, one end of the gate semiconductor layer 150 may be aligned with the side surface of the gate spacer 200 in the third direction (Z direction).

In the process of patterning the gate semiconductor material layer 150m, the portion of the gate semiconductor material layer 150m positioned between the gate spacer 200 and the gate electrode 165 may be etched together. For example, as shown in FIG. 24A, the gate semiconductor material layer 150m may be patterned to form a first pattern portion 151 overlapping the gate electrode 165 in a third direction (Z direction), and a second pattern portion 152 overlapping the gate spacer 200 in a third direction (Z direction). The second pattern portion 152 may be spaced apart from the first pattern portion 151 in the first direction (X direction). As another example, as shown in FIG. 24B, a portion of the gate semiconductor material layer 150m positioned between the gate spacer 200 and the gate electrode 165 may not be completely removed. That is, the gate semiconductor material layer 150m may be patterned to form a first pattern portion 151 overlapping the gate electrode 165 in the third direction (Z direction), a second pattern portion 152 overlapping the gate spacer 200 in the third direction (Z direction), and a third pattern portion 153 positioned between the first pattern portion 151 and the second pattern portion 152.

Subsequently, a protective layer 180 may be formed on the barrier layer 136, and a source electrode 170 and a drain electrode 190 passing through the protective layer 180 and the barrier layer 136 may be formed, thereby forming a semiconductor device of FIG. 7 and FIG. 8.

In some implementations, a method of manufacturing a semiconductor device includes forming a barrier layer on a channel layer, wherein the barrier layer includes a material having a different energy band gap from an energy band gap of the channel layer, forming a gate semiconductor material layer and a gate electrode material layer on the barrier layer, patterning the gate electrode material layer to form a gate electrode and etching at least a portion of the gate semiconductor material layer, forming a gate spacer on the gate semiconductor material layer, patterning the gate semiconductor material layer using the gate spacer as a mask to form a gate semiconductor layer, and forming a source electrode and a drain electrode connected to the channel layer through the barrier layer.

In some implementations, the step of etching at least a portion of the gate semiconductor material layer may include forming a first pattern portion overlapping the gate electrode by using the gate electrode as a mask and second preliminary pattern portions positioned at opposite sides of the first pattern portion.

In some implementations, the step of forming the gate semiconductor layer may include a step of forming a second pattern portion by patterning the second preliminary pattern portion using the gate spacer as a mask.

In some implementations, a side surface of the second pattern portion may be aligned with a side surface of the gate spacer.

In some implementations, the thickness of the second pattern portion may be less than the thickness of the first pattern portion.

In some implementations, the gate spacer may be in contact with a side surface of the first pattern portion.

In some implementations, the gate spacer may be in contact with a side surface of the gate electrode.

In some implementations, the second pattern portion may be spaced apart from the first pattern portion.

In some implementations, the gate spacer may be spaced apart from the gate electrode.

In some implementations, a protective layer is positioned on the gate electrode and the barrier layer, and a field dispersion layer is positioned on the protective layer and connected to the source electrode, where a distance between the field dispersion layer and the drain electrode may be less than a distance between the second pattern portion and the drain electrode.

Embodiments are set out in the following Clauses:
Clause 1. A semiconductor device comprising:
   a channel layer;
   a barrier layer on the channel layer, the barrier layer including a material having a first energy band gap different from a second energy band gap of the channel layer;
   a gate electrode on the barrier layer;
   a gate semiconductor layer between the barrier layer and the gate electrode;
   a gate spacer on a first side and a second side of the gate semiconductor layer, the first side of the gate semiconductor layer being opposite the second side of the gate semiconductor layer; and
   a source electrode on a first side of the gate electrode and a drain electrode on a second side of the gate electrode, the first side of the gate electrode being opposite the second side of the gate electrode, and the source electrode and the drain electrode being connected to the channel layer,
   wherein the gate semiconductor layer comprises
      a first pattern portion overlapping the gate electrode, and
      a second pattern portion extending from a side of the first pattern portion, wherein the second pattern portion is between the gate spacer and the barrier layer, and
      wherein a width of the second pattern portion is less than a width of the first pattern portion.
Clause 2. The semiconductor device of Clause 1, wherein the width of the second pattern portion is 1/10 to 1/5 of the width of the first pattern portion.
Clause 3. The semiconductor device of Clause 1 or Clause 2, comprising:
   a hard mask layer on the gate electrode, wherein the gate spacer contacts at least a portion of a side surface of the hard mask layer.
Clause 4. The semiconductor device of any preceding Clause, comprising:
   a protective layer on the gate electrode and the barrier layer; and
   a field dispersion layer on the protective layer and connected to the source electrode,
   wherein a distance between the second pattern portion and the drain electrode is greater than a distance between the field dispersion layer and the drain electrode.
Clause 20. A semiconductor device comprising:
   a channel layer comprising GaN;
   a barrier layer on the channel layer, the barrier layer comprising AlGaN;
   a gate electrode on the barrier layer;
   a hard mask layer on the gate electrode;
   a gate semiconductor layer between the barrier layer and the gate electrode, the gate semiconductor layer comprising GaN doped with p-type impurity;
   a gate spacer on a first side and a second side of the gate semiconductor layer, the first side of the gate semiconductor layer being opposite the second side of the gate semiconductor layer, the gate spacer on a side surface of the gate electrode and on a side surface of the hard mask layer;
   a protective layer on the barrier layer, the gate spacer, and the hard mask layer; and
   a source electrode on a first side of the gate electrode and a drain electrode on a second side of the gate electrode, the first side of the gate electrode being opposite the second side of the gate electrode, the source electrode and the drain electrode being connected to the channel layer,
   wherein the gate semiconductor layer comprises
      a first pattern portion overlapping the gate electrode, and
      a second pattern portion between the gate spacer and the barrier layer,
      wherein a thickness of the second pattern portion is less than a thickness of the first pattern portion, and
      wherein a side surface of the second pattern portion is aligned with a side surface of the gate spacer.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While implementations of the present disclosure have been described in detail above, the scope of rights of the present disclosure is not limited thereto, and various modifications and improved forms by those skilled in the art utilizing the basic concepts of the present disclosure as defined in the following claims also fall within the scope of rights of the present disclosure.

## Claims

1. A semiconductor device comprising:
a channel layer (132);
a barrier layer (136) on the channel layer (132), the barrier layer (136) including a material having a first energy band gap different from a second energy band gap of the channel layer (132);
a gate electrode (165) on the barrier layer (136);
a gate semiconductor layer (150) between the barrier layer (136) and the gate electrode (165);
a gate spacer (200) on a first side and a second side of the gate semiconductor layer (150), the first side of the gate semiconductor layer (150) being opposite the second side of the gate semiconductor layer (150); and
a source electrode (170) on a first side of the gate electrode (165) and a drain electrode (190) on a second side of the gate electrode (165), the first side of the gate electrode (165) being opposite the second side of the gate electrode (165), and the source electrode (170) and the drain electrode (190) being connected to the channel layer (132),
wherein the gate semiconductor layer (150) comprises
a first pattern portion (151) overlapping the gate electrode (165), and
a second pattern portion (152) on a first side and a second side of the first pattern portion (151), the first side of the first pattern portion (151) being opposite the second side of the first pattern portion (151), and the second pattern portion (152) overlapping the gate spacer (200),
wherein a side surface of the second pattern portion (152) is aligned with a side surface of the gate spacer (200).

2. The semiconductor device of claim 1, wherein a width of the second pattern portion (152) in a first direction is less than a width of the first pattern portion (151) in the first direction.

3. The semiconductor device of claim 2, wherein the width of the second pattern portion (152) in the first direction is 0.03 µm to 0.3 µm.

4. The semiconductor device of claim 2 or claim 3, wherein the second pattern portion (152) comprises a section having a width in the first direction that decreases with increasing distance from an upper surface of the barrier layer (136).

5. The semiconductor device of any preceding claim, wherein a thickness of the second pattern portion (152) is less than a thickness of the first pattern portion (151).

6. The semiconductor device of claim 5, wherein the thickness of the second pattern portion (152) is 3 nm to 30 nm.

7. The semiconductor device of any preceding claim, wherein the gate spacer (200) contacts a side surface of the first pattern portion (151).

8. The semiconductor device of claim 7, wherein the gate spacer (200) contacts a side surface of the gate electrode (165).

9. The semiconductor device of any preceding claim, comprising:
a protective layer (180) on the gate electrode (165) and the barrier layer (136), and
a field dispersion layer (177) on the protective layer (180) and connected to the source electrode (170), and
wherein a distance between the second pattern portion (152) and the drain electrode (190) is greater than a distance between the field dispersion layer (177) and the drain electrode (190).

10. The semiconductor device of any preceding claim, wherein the gate semiconductor layer (150) comprises:
a third pattern portion (153) between the first pattern portion (151) and the second pattern portion (152), wherein a thickness of the third pattern portion (153) is less than or equal to a thickness of the second pattern portion (152).

11. The semiconductor device of claim 10, wherein the third pattern portion (153) is spaced apart from the gate spacer (200).

12. The semiconductor device of any preceding claim, wherein the second pattern portion (152) is spaced apart from the first pattern portion (151).

13. The semiconductor device of claim 12, wherein the gate spacer (200) is spaced apart from the gate electrode (165).

14. The semiconductor device of any preceding claim, wherein the first pattern portion (151) comprises:
a first pattern layer (151a) on the barrier layer (136), wherein the first pattern layer (151a) comprises GaN;
a second pattern layer (151b) on the first pattern layer (151a), wherein the second pattern layer (151a) comprises AlGaN or InGaN; and
a third pattern layer (151c) on the second pattern layer (152b), wherein the third pattern layer (151c) comprises GaN,
wherein the second pattern layer (151b) is spaced apart from the second pattern portion (152) in a first direction, and wherein a thickness of the second pattern layer (151b) is less than a thickness of the first pattern layer (151a) and a thickness of the third pattern layer (151c).

15. The semiconductor device of claim 14, wherein a content of Al or a content of In of the second pattern layer (151b) is 5 at% to 15 at%.
